# EUROPÄISCHE PATENTSCHRIFT

(11) **EP 1 721 347 B1**
(45) Veröffentlichungstag und Bekanntmachung des Hinweises auf die Patenterteilung: **15.12.2010**
(21) Anmeldenummer: 05729708.7
(22) Anmeldetag: 03.03.2005
(51) Int. Cl.: H01L 51/30, C07F 11/00, C07F 5/02

(54) **VERWENDUNG VON METALLKOMPLEXEN ALS N-DOTANDEN FÜR ORGANISCHE HALBLEITER**
USE OF A METAL COMPLEX AS N-DOPANT FOR AN ORGANIC SEMICONDUCTING MATRIX MATERIAL
UTILISATION D'UN COMPLEXE METALLIQUE COMME DOPANT N D'UN MATERIAU MATRICE SEMI-CONDUCTEUR ORGANIQUE

(30) Priorität: 03.03.2004 DE 102004010954
(43) Veröffentlichungstag der Anmeldung: 15.11.2006
(60) Teilanmeldung: 06007372.3
(73) Patentinhaber: Novaled AG, 01307 Dresden (DE)
(72) Erfinder: WERNER, Ansgar, 01277 Dresden (DE); KÜHL, Olaf, 04416 Markkleeberg (DE); GESSLER, Simon, 60594 Frankfurt (DE); HARADA, Kentaro, 01307 Dresden (DE); HARTMANN, Horst, 01326 Dresden (DE); GRÜSSING, Andre c/o Novaled GmbH, 01307 Dresden (DE); LIMMERT, Michael, 01277 Dresden (DE); LUX, Andrea, 01277 Dresden (DE)
(74) Vertreter: Bittner, Thomas L.
(86) Internationale Anmeldenummer: PCT/DE2005/000372
(87) Internationale Veröffentlichungsnummer: WO 2005/086251

(56) Entgegenhaltungen:
- WO-A-03/022008
- WO-A-03/088271
- WO-A-2004/008554
- WO-A-2004/010136
- WO-A-2004/017043
- WO-A-2005/056717
- US-A1- 2002 142 189
- US-A1- 2002 179 885
- US-A1- 2003 072 965
- US-A1- 2003 203 168
- BLOOM C J ET AL: "Low work function reduced metal complexes as cathodes in organic electroluminescent devices" JOURNAL OF PHYSICAL CHEMISTRY. B, MATERIALS, SURFACES, INTERFACES AND BIOPHYSICAL, WASHINGTON, DC, US, Bd. 107, Nr. 13, 3. April 2003 (2003-04-03), Seiten 2933-2938, XP002317496 ISSN: 1089-5647
- HARADA K ET AL: "Realization of organic pn-homojunction using a novel n-type doping technique" PROCEEDINGS OF THE SPIE, SPIE, BELLINGHAM, VA, US, Bd. 5464, September 2004 (2004-09), Seiten 1-9, XP002317497 ISSN: 0277-786X
- PFEIFFER M ET AL: "DOPED ORGANIC SEMICONDUCTORS: PHYSICS AND APPLICATION IN LIGHT EMITTING DIODES" ORGANIC ELECTRONICS, ELSEVIER, AMSTERDAM, NL, Bd. 4, Nr. 2/3, September 2003 (2003-09), Seiten 89-103, XP001177135 ISSN: 1566-1199
- U. RADIUS AND J. ATTNER: "Dinuclear Molybdenum(III) and Tungsten(III) Calix[4]arene Complexes - Metal-Metal Triple Bonds Supported by Bridging Calix[4]arene Ligands" EUROPEAN JOURNAL OF INORGANIC CHEMISTRY, Nr. 3, 7. Dezember 1998 (1998-12-07), Seiten 299-303, XP002347767
- M. H. CHISHOLM ET AL: "Preparation and characterization of the kinetic and thermodynamic isomers of dinuclear molybdenum and tungsten complexes with metal?metal triple bonds supported by p-tert-butylcalix[4]arene anions" CHEMICAL COMMUNICATIONS, Nr. 3, 1998, Seiten 379-380, XP002347768

## Beschreibung

Die Erfindung betrifft die Verwendung eines Metallkomplexes als Dotand zur Dotierung eines organischen halbleitenden Matrixmaterials zur Veränderung der elektrischen Eigenschaften desselben, wobei die Verbindung bezüglich des Matrixmaterials einen n-Dotanden darstellt, sowie ein elektronisches Bauelement

Es ist bekannt, organische Halbleiter durch Dotierung hinsichtlich ihrer elektrischen Eigenschaften, insbesondere ihrer elektrischen Leitfähigkeit, zu verändern, wie dies auch bei anorganischen Halbleitern wie Siliciumhalbleitern der Fall ist. Hierbei wird durch Erzeugung von Ladungsträgern im Matrixmaterial eine Erhöhung der zunächst recht niedrigen Leitfähigkeit sowie je nach Art des verwendeten Dotanden eine Veränderung im Fermi-Niveau des Halbleiters erreicht. Eine Dotierung führt hierbei zu einer Erhöhung der Leitfähigkeit von Ladungstransportschichten, wodurch ohmsche Verluste verringert werden, und zu einem verbesserten Übergang der Ladungsträger zwischen Kontakten und organischer Schicht. Anorganische Dotanden sind bei organischen Matrixmaterialien aufgrund ihrer hohen Diffusionskoeffizienten meist nachteilig, da sie die Funktion und Stabilität der elektronischen Bauelemente beeinträchtigen. Ferner ist es bekannt, Dotanden über chemische Reaktionen in dem halbleitenden Matrixmaterial freizusetzen, um Dotanden bereitzustellen. Das Oxidationspotential der derart freigesetzten Dotanden ist jedoch für verschiedene Anwendungsfälle wie insbesondere für organische Leuchtdioden (OLED) oftmals nicht ausreichend. Ferner werden bei Freisetzung der Dotanden auch weitere Verbindungen und/oder Atome, beispielsweise atomarer Wasserstoff, erzeugt, wodurch die Eigenschaften der dotierten Schicht bzw. des korrespondierenden elektronischen Bauelementes beeinträchtigt werden.

Ferner haben als Dotanden verwendete organische Verbindungen oftmals ein nicht ausreichend niedriges Oxidationspotential für den jeweiligen Anwendungsfall.

Aus der WO03/088271 A1 ist ein Ladungstransportmaterial bekannt, das eine organische Matrix und einen organometallischen Dotanden umfasst, wobei das Ladungstransportmaterial eine höhere Leitfähigkeit als die nicht dotierte organische Matrix zeigt. Der organometallische Dotand ist ein neutraler n-Dotand, wie beispielsweise Cp₂Fe.

Die US 2003/0203168 A1 offenbart eine organische Diode, wobei in der halbleitenden/aktiven Schicht bzw. in dem funktionell wirksamen Bereich ein Gemisch aus einem dinuklearen Metallkomplex, an welchen ausschließlich Heteroatome binden, und einer organischen Verbindung vorliegt. Der Metallkomplex weist zwei unterschiedliche Ligandenarten auf, nämlich zum einen axiale Liganden Lₐₓ, und zum anderen äquatoriale Liganden L_{aq}, wobei jeweils zwei dieser äquatorialen Liganden einen zweizähnigen Liganden bilden.

Der Erfindung liegt die Aufgabe zugrunde, Metallkomplexe als n-Dotanden zur Dotierung eines organischen halbleitenden Matrixmaterials, insbesondere zur Herstellung elektronischer Bauelemente anzugeben, die insbesondere auch zur Herstellung von E-lektronentransportmaterialien für organische Leuchtdioden (OLED) ausreichend niedrige Oxidationspotentiale aufweisen, ohne störende Einflüsse auf das Matrixmaterial zu haben, und eine wirksame Erhöhung der Ladungsträgeranzahl in dem Matrixmaterial bewirken und vorzugsweise vergleichsweise einfach handhabbar sind. Ferner ist es eine Aufgabe der Erfindung, ein elektronisches

Bauelement mit einem elektronisch funktionell wirksamen Bereich bereitzustellen.

Diese Aufgaben werden durch die Merkmale der unabhängigen Ansprüche 1 und 2, insbesondere durch die Verwendung von neutralen elektronenreichen Metallkomplexen gelöst. Bevorzugte Ausführungsformen ergeben sich aus den Unteransprüchen.

Dadurch, dass ein elektronenreicher Metallkomplex in neutraler Form als n-Dotand gegenüber dem organischen halbleitenden Matrixmaterial eingesetzt wird, liegt ein wesentlich stärkerer Donor vor, als bei bisher bekannten organischen Donorverbindungen. Ferner können durch die Bereitstellung eines neutralen elektronenreichen Metallkomplexes gegenüber anderen n-Dotanden in Form organischer Verbindung die Donor-Eigenschaften der Verbindung durch Auswahl eines geeigneten Zentralatoms und damit deren Oxidationspotential variiert werden. Die n-Dotanden weisen somit vorzugsweise ein sehr niedriges Oxidationspotential auf. Insbesondere kann durch die erfindungsgemäßen n-Dotanden die Leitfähigkeit von Ladungstransportschichten wesentlich erhöht und/oder der Übergang der Ladungsträger zwischen Kontakten und organischer Schicht bei Anwendungen als elektronisches Bauelement wesentlich verbessert werden.

Die erfindungsgemäß verwendeten Metallkomplexe stellen vorzugsweise isolierte Moleküle dar, die somit vorzugsweise in der jeweiligen halbleitenden Schicht als isolierte Moleküle vorliegen, die nicht durch chemische Bindungen untereinander und/oder an eine Matrix und/oder an eine andere Komponente fixiert sind. Vorzugsweise werden die Valenzelektronen der Metallzentralatome, abgesehen von den dem Metallatom unmittelbar zuzuordnenden Valenzelektronen des Komplexes, somit im wesentlichen oder vollständig von den Liganden des Komplexes und den Metallatomen des Komplexes, die innerhalb der durch die Liganden gebildeten vorzugsweise zumindest im wesentlichen geschlossenen Koordinationssphäre angeordnet sind, bereitgestellt. Es versteht sich, dass einzelne Metallkomplexe jeweils untereinander oder mit anderen Komponenten wie dem Matrixmaterial gebunden sein können, um gegebenenfalls die Metallkomplexe zu immobilisieren. Hierzu können beispielsweise die Liganden geeignete funktionelle Gruppen aufweisen, die miteinander verbindbar sind, beispielsweise ungesättigte Gruppen, die miteinander unter Bildung eines Oligomeren oder Polymeren linear oder verzweigt reagieren können.

Die erfindungsgemäßen Komplexe sind zweikernige Komplexe mit zumindest einer Metall-Metall-Bindung zwischen den Zentralatomen wodurch jeweils besonders elektronenreiche Metallkomplexe mit einer hohen Elektronendichte am Zentralatom des Metallkomplexes bereitgestellt werden können.

Besonders bevorzugt ist als Zentralatom des elektronenreichen Metallkomplexes ein neutrales oder geladenes Übergangsmetallatom. Das Zentralatom kann beispielsweise ein Metallatom aus der Gruppe der ersten Übergangsmetallperiode (Scandium bis Zink) sein, oder ein Metall der zweiten Übergangsmetallperiode (Yttrium bis Cadmium), z.B. Rhodium, Palladium, Silber und Cadmium sein, oder ein Metall der dritten Übergangsmetallperiode, einschließlich jeweils Lanthaniden und Actiniden. Das Zentralatom kann insbesondere ein Metall der 7. bis 10. Gruppe sein. Das Übergangsmetall des mindestens einen Zentralatoms kann auch jeweils eines der folgenden Elemente sein: V, Cr, Mn, Fe, Co, Ni, Cu, Zn, Nd, Ta, Mo, W, Rh, Ir, Pd, Pt. Besonders bevorzugt ist das Übergangsmetallatom ausgewählt aus der Gruppe Mn, Fe, Co, Ni, Cu, Zn, beispielsweise ausgewählt aus der Gruppe Fe, Co, Ni. Ferner kann das Übergangsmetallatom ausgewählt sein aus der Gruppe Cr, Mo, W. Das Übergangsmetallatom kann auch ausgewählt sein aus der Gruppe V, Nb, Ta oder aus der Gruppe Ir, Pt, Au, Hg. Für verschiedene Anwendungszwecke sind jedoch auch Metallkomplexe mit einer geringeren formalen Valenzelektronenzahl am Metallzentralatom des Komplexes bzw. mit einer niedrigeren Elektronendichte am Metallzentralatom einsetzbar.

Das Übergangsmetallatom kann in dem erfindungsgemäß verwendeten neutralen Metallkomplex als Neutralatom vorliegen oder als geladenes Übergangsmetallatom, vorzugsweise mit einer Formalladung von 0 bis 3, beispielsweise einer Formalladung von 0, 1 oder 2, wobei das Zentralatom insbesondere ein Atom der ersten Übergangsmetallperiode darstellen kann. Die Ladung des Zentralatoms, welches ein Atom der ersten, zweiten oder dritten Übergangsmetallperiode darstellen kann, kann auch von 0 verschieden sein.

Der Metallkomplex weist einen der Strukturtypen 65a, 65b, 65c und 65d auf, die im Folgenden näher beschrieben werden: 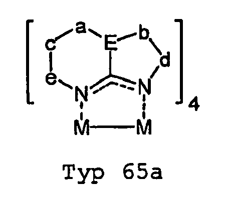 wobei
- die Strukturelemente a-e die Bedeutung: a = -CR₁R₂-, b = -CR₃R₄-, c = -CR₅R₆-, d = -CR₇R₈- und e = -CR₉R₁₀- haben können, wobei R₁, R₂, R₃, R₄, R₅, R₆, R₇, R₈, R₉ und R₁₀ gleichzeitig oder unabhängig voneinander H, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sind, vorzugsweise sind R₁, R₃, R₅, R₇, R₉ = H und R₂, R₄, R₆, R₈, R₁₀ = Alkyl mit C₁-C₂₀, Cycloalkyl mit C₁-C₂₀, Alkenyl mit C₁-C₂₀, Alkinyl mit C₁-C₂₀, Aryl, Heteroaryl, -NR₂ oder -OR, oder
- wahlweise a oder b oder e oder d NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und d oder b und e NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- bei c C durch Si ersetzt ist,
- wobei die Bindungen b-d und c-e oder b-d und a-c gleichzeitig oder unabhängig voneinander ungesättigt sein können,
- wobei die Bindungen b-d, a-c und c-e gleichzeitig oder unabhängig voneinander Teil eines gesättigten oder ungesättigten Ringsystems sein können, welches auch die Heteroelemente O, S, Se, N, P, Si, Ge, Sn enthalten kann, oder
- wobei die Bindungen b-d, a-c und c-e gleichzeitig oder unabhängig voneinander Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann,
- wobei das Metall M ein Übergangsmetall ist, vorzugsweise W oder Mo; 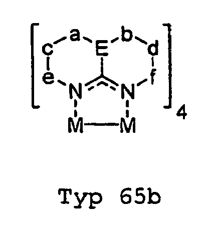 wobei
- die Strukturelemente a-f die Bedeutung: a= -CR₁R₂-, b = -CR₃R₄-, c = -CR₅R₆-, d = -CR₇R₈-, e = -CR₉R₁₀- und f = CR₁₁R₁₂ haben können, wobei R₁, R₂, R₃, R₄, R₅, R₆, R₇, R₈, R₉, R₁₀, R₁₁ und R₁₂ Wasserstoff, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sind, vorzugsweise sind R₁, R₃, R₅, R₇, R₉, R₁₁ = H und R₂, R₄, R₆, R₈, R₁₀, R₁₂ = Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR, oder
- bei den Strukturelementen c und/oder d C durch Si ersetzt sein kann, oder
- wahlweise a oder b oder e oder f NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und f oder b und e NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, b-d, c-e und d-f, aber nicht gleichzeitig a-c und c-e und nicht gleichzeitig b-d und d-f ungesättigt sein können,
- wobei die Bindungen a-c, b-d, c-e und d-f Teil eines gesättigten oder ungesättigten Ringsystems sein können, welches auch die Heteroelemente O, S, Se, N, P, Si, Ge, Sn enthalten kann, oder
- die Bindungen a-c, b-d, c-e und d-f Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann,
- wobei das Metall M ein Übergangsmetall, vorzugsweise W oder Mo ist; 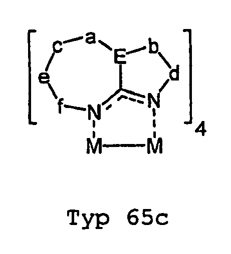 wobei
- die Strukturelemente a-f die Bedeutung: a = -CR₁R₂-, b = -CR₃R₉-, c = -CR₅R₆-, d = -CR₇R₈-, e = -CR₉R₁₀- und f = CR₁₁R₁₂ haben können, wobei Ri, R₂, R₃, R₄, R₅, R₆, R₇, R₈, R₉, R₁₀, R₁₁ und R₁₂ gleichzeitig oder unabhängig voneinander H, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sein kann; vorzugsweise ist R₁, R₃, R₅, R₇, R₉, R₁₁ = H und R₂, R₄, R₆, R₈, R₁₀, R₁₂ = Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR, oder
- bei c oder e C durch Si ersetzt sein kann, oder
- wahlweise a oder b oder d oder f NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und d oder b und f NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, c-e, e-f und b-d, aber nicht gleichzeitig a-c, c-e und e-f und nicht gleichzeitig a-c und c-e und nicht gleichzeitig c-e und e-f ungesättigt sein können,
- wobei die Bindungen a-c, c-e, e-f und b-d Teil eines gesättigten oder ungesättigten Ringsystems sein können, welches auch die Heteroelemente 0, S, Se, N, P, Si, Ge, Sn enthalten kann, oder
- die Bindungen a-c, c-e, e-f und b-d Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann,
- wobei das Metall M ein Übergangsmetall ist, vorzugsweise W oder Mo; oder 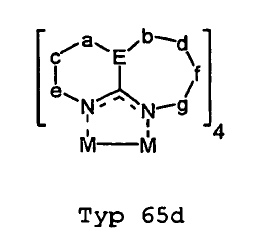
- wobei die Strukturelemente a-g die Bedeutung: a = - CR₁R₂-, b = -CR₃R₄-, c = -CR₅R₆-, d = -CR₇R₈-, e = - CR₉R₁₀-, f = CR₁₁R₁₂ und g = CR₁₃R₁₄ haben können, wobei R₁, R₂, R₃, R₄, R₅, R₆, R₇, R₈, R₉, R₁₀, R₁₁, R₁₂, R₁₃ und R₁₄ gleichzeitig oder unabhängig voneinander H, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sein kann; vorzugsweise ist R₁, R₃, R₅, R₇, R₉, R₁₁, R₁₃ = H und R₂, R₄, R₆, R₈, R₁₀, R₁₂, R₁₄ = Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR, oder
- bei c, d und f, jedoch nicht d und f gleichzeitig, C durch Si ersetzt sein kann, oder
- wahlweise a oder b oder e oder g NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und g oder b und e NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, c-e, b-d, d-f und f-g, aber nicht gleichzeitig a-c und c-e, und nicht gleichzeitig b-d, d-f und f-g, und nicht gleichzeitig b-d und d-f, und nicht gleichzeitig d-f und f-g, ungesättigt sein können,
- wobei die Bindungen a-c, c-e, b-d, d-f und f-g Teil eines gesättigten oder ungesättigten Ringsystems sein können, welches auch die Heteroelemente O, S, Se, N, P, Si, Ge, Sn enthalten kann, oder
- die Bindungen a-c, c-e, b-d, d-f und f-g Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann
- wobei das Metall M ein Übergangsmetall ist, vorzugsweise W oder Mo.

Der Rest R in den Strukturen 65a-65d kann ein beliebiger organischer Rest einschließlich Wasserstoff, insbesondere auch ein Kohlenwasserstoffrest oder ein substituierter oder unsubstituierter Alkylrest, im Besonderen ein Alkylrest mit C₁ bis C₁₀, insbesondere C₁ bis C₄ oder bis C₆, sein.

### Ionisationspotential/Oxidationspotential

Vorzugsweise weist der Metallkomplex ein Ionisationspotential in der Gasphase von ≤ 6,4 eV, vorzugsweise von ≤ 6 eV, insbesondere ≤ 5,5 eV auf. Insbesondere kann das Ionisationspotential des Komplexes in der Gasphase ≤ 5,0 eV oder ≤ 4,5 eV sein.

Das Gasphasenionisationspotential Ipg der erfindungsgemäß einsetzbaren Verbindungen kann beispielsweise gegenüber Tetrathiafulvalen (TTF) bestimmt werden, welches beträgt: Ipg = 6,4 eV (siehe R. Gleiter, E. Schmidt, D. O. Cowan, J P. Ferraris, J. Electr. Spec. Rel. Phenom. 2, 207 (1973)).

Das Oxidationspotential von TTF ist E1/2(ox) = -0,09 V gegenüber Fe/Fe+ (Ferrocen/Ferrocenium) (M. Iyoda, T. Takano, N. O-tani, K. Ugawa, M. Yoshida, H. Matsuyama, Y. Kuwatani, Chem. Lett., 1310 (2001)). Ausgehend von diesem Referenzpunkt kann somit das Redoxpotential der erfindungsgemäßen n-Dotanden gegenüber Ferrocen/Ferrocenium ≤ -0,09 V, vorzugsweise ≤ -0,6 V, besonders bevorzugt ≤ -1,1 V betragen, beispielsweise ≤ -1,6 V oder ≤ -2,1 V betragen, ohne hierauf beschränkt zu sein.

Das Oxidationspotential gegenüber Ferrocen/Ferrocenium kann beispielsweise cyclovoltammetrisch bestimmt werden. Das Potential ist hierbei weitgehend unabhängig von dem gewählten Elektrolytsystem und kann gemäß IUPAC Empfehlung (Gritzner, G.; Kuta, J. Pure Appl. Chem. 1984, 56, 461-466) bestimmt werden. Das Elektrolytsystem muss ein ausreichend großes elektrochemisches Fenster und eine ausreichende Löslichkeit der Donorverbindung aufweisen. Als Elektrolytsystem ist beispielsweise geeignet A-cetronitril / 1M LiClO₄/Pt Elektroden, wobei auch andere geeignete Elektrolytsysteme einsetzbar sind.

### Dampdfruck

Der Dampfdruck des erfindungsgemäß eingesetzten Komplexes kann insbesondere bei 30°C < 10⁻³ Pa sein, beispielsweise ≤ 5 x 10⁻⁴ Pa oder ≤ 1 x 10⁻⁴ Pa.

Die jeweils verwendeten erfindungsgemäßen n-Dotanden und/oder die jeweils verwendeten Komplexe können luftstabil sein, gegebenenfalls können die jeweils verwendeten erfindungsgemäßen n-Dotanden und/oder Komplexe jeweils auch luftinstabil sein.

### Synthese der erfindungsgemäßen n-Dotandenkomplexe und deren Liganden

### Allgemeines

Die Synthese der erfindungsgemäßen n-Dotanden Metallkomplexe kann beispielsweise durch unmittelbare Synthese der Verbindungen oder durch Reduktion von Salzen erfolgen, wobei der resultierende neutrale Metallkomplex in dem Salz als Kation vorliegt. Das Anion kann jedes beliebige geeignete Anion darstellen, beispielsweise Halogen, Perchlorat, Sulfat oder dergleichen. Die Reduktion kann beispielsweise elektrochemisch oder chemisch erfolgen, ohne hierauf beschränkt zu sein. Die Reduktion kann beispielsweise durch Elektrokristallisation erfolgen, wobei das hierdurch gewonnene Produkt, welches an der Arbeitselektrode geerntet werden kann, nachfolgend gereinigt werden kann. Die Herstellung der erfindungsgemäßen Komplexe kann insbesondere aber auch ohne Anwendung eines derartigen Elektrokristallisationsschrittes erfolgen.

### Syntheseverfahren

Die erfindungsgemäßen Komplexe lassen sich nach bekannten Verfahren synthetisieren, teilweise sind sie auch kommerziell erhältlich. Die Synthese der Liganden der erfindungsgemäßen Komplexe und der Komplexe selber sind beispielsweise in folgenden Literaturstellen beschrieben. Es versteht sich, dass die genannten Literaturstellen nur beispielhaft angegeben sind und die Liganden und Komplexe meist auch durch andere geeignete Verfahren synthetisierbar sind.

### Paddlewheel-Komplexe

Die Paddlewheel-Komplexe können entweder durch Ligandensubstitution aus anderen Paddlewheel-Komplexen (F. A. Cotton, J. G. Norman Jr., J. Coord. Chem. 1 (1970) 161-72; F. A. Cotton, D. J. Timmons, Polyhedron 17 (1998) 179-84), durch Salzmetathese aus dem Metallhalogenid und einem anionischen Liganden (F. A. Cotton, D. J. Timmons, Polyhedron 17 (1998) 179-84), durch Reduktion eines kationischen Paddlewheel-Komplexes (F. A. Cotton, P. Huang, C. A. Murillo, X. Wang, Inorg. Chem. Commun. 6 (2003) 121-6) oder in einer Redoxreaktion aus einer Metallverbindung und dem Liganden (T. A. Stephenson, E. Bannister, G. Wilkinson, J. Chem. Soc. (1964) 2538-41) dargestellt werden.

Darüber hinaus wurde ein neues Verfahren entwickelt, nach dem sich die Paddlewheel Komplexe vom Typ 65a-d effizient in einer Einstufensynthese darstellen lassen. Dazu wird ein entsprechendes anorganisches Metallsalz mit freien Basen der in 65 a-d angegebenen Liganden und einem geeigneten starken Reduktionsmittel in einem geeigneten organischen Lösungsmittel zum Rückfluß erhitzt, bis die Umsetzung vollständig abgelaufen ist. Als geeignete Lösungsmittel werden vorzugsweise solche eingesetzt, in denen die gebildeten Komplexe eine hinreichende Stabilität aufweisen, vorzugsweise jedoch Dialkylether, cyclische Ether, cyclische und offenkettige Polyether wie 1,4-Dioxan, Dimethoxyethan, etc., Aromaten und Mischungen derselben.
Geeignete Reduktionsmittel sind beispielsweise unedle Metalle, bevorzugt Alkalimetalle wie Natrium, Kalium und Cäsium.
Die Komplexe werden nach Abtrennen der anorganischen Nebenprodukte durch Kristallisation, Fällen oder Sublimation isoliert.

Durch die neuartige Einstufensynthese wird ein zeit und resourcensparender Zugang zu Komplexen des Typs W₂L₄ eröffnet.

Im Weiteren folgen Ausführungsbeispiele:

### Synthese der Liganden und ihrer Vorstufen

### Beispiel 1:

### 1. Imidazo[1,2-a]pyrimidin Hydroperchlorat

Die Herstellung erfolgte nach einer in der Literatur beschriebenen Methode (M. Künstlinger, E. Breitmaier, Synthesis 1983 (2), 161-162). Davon abweichend wurde das Produkt durch Zugabe von Perchlorsäure als Imidazo[1,2-a]pyrimidin Hydroperchlorat isoliert.
Fp. 195 °C
¹H-NMR (500 MHz, CD₃CN) [ppm]:
8,99-8,96 (m, 2H); 7,98 (d, 1H); 7,93 (d, 1H); 7,58 (dd, 1H) MS: m/z = 119 [M]⁺

### 2. 5,6,7,8-Tetrahydro-imidazo[1,2-a]pyrimidin

4,2 g Imidazo[1,2-a]pyrimidin Hydroperchlorat wurden in essigsaurer Lösung mit Palladium auf Aktivkohle 8 h unter H₂-Zufuhr erwärmt. Anschließende Filtration, Entfernen des Lösungsmittels und Zugabe von Diethylether lieferte das 5,6,7,8-Tetrahydro-imidazo[1,2-a]pyrimidin Hydroacetat als farblose Kristalle, die aus Ethanol umkristallisiert wurden.
Ausbeute: 3,21 g
Fp. 65°C
¹H-NMR (500 MHz, DMSO-d₆) [ppm] :
6,97 (d, 1H); 6,91 (d, 1H); 3,90 (t, 2H); 3,25 (t, 2H); 1,98 (quint., 2H)

Die Freisetzung des 5,6,7,8-Tetrahydro-imidazo[1,2-a]pyrimidins erfolgte in alkalischer Ethanollösung.
Ausbeute: 3,08 g
Fp. 110°C
¹H-NMR (500 MHz, DMSO-d₆) [ppm]:
6,51 (d, 1H); 6,36 (d, 1H); 6,09 (s, 1H); 3,80 (t, 2H); 3,16 (t, 2H); 1,90 (quint., 2H)
MS: m/z = 123 [M]⁺

### Beispiel 2:

### 1. 2-Amino-4,6-dimethyl-1,4,5,6-tetrahydropyrimidin

1 g 2-Amino-4,6-dimethylpyrimidin wurden im salzsauren Milieu (2 M HCl) mit Palladium auf Aktivkohle als Katalysator für 14 h unter H₂-Zufuhr erwärmt. Anschließende Filtration, Entfernung des Lösungsmittels und Zugabe von Diethylether lieferte das 2-Amino-4,6-dimethyl-1,4,5,6-tetrahydropyrimidin Hydrochlorid, das aus i-Propanol/Diethylether umkristallisiert und im Vakuum getrocknet wurde.
Ausbeute: 1,03 g
Fp. 129°C
¹H-NMR (500 MHz, DMSO-d₆) [ppm]:
8,14 (s, 2H); 6,81 (s, 2H); 3,48 (m, 2H); 1,98 (d, 1H); 1,14 (d, 6H) ; 1,10 (d, 1H)

Die Freisetzung des 2-Amino-4,6-dimethyl-1,4,5,6-tetrahydropyrimidins erfolgte in alkalischer Ethanollösung.
¹H-NMR (500 MHz, DMSO-d₆) [ppm]:
3,46 (m, 2H); 1,98 (m, 1H); 1,13 (d, 6H); 1,10 (d, 1H)

### 2. 2,4-Dimethyl-3,4-dihydro-2H-pyrimido[1,2-a]pyrimidin Hydroperchlorat

0,66 g 2-Amino-4,6-dimethyl-1,4,5,6-tetrahydropyrimidin wurden in methanolischer Lösung unter Zugabe von Perchlorsäure mit einer äquimolaren Menge von 1,1,3,3-Tetramethoxypropan unter Rückfluss zum Sieden erhitzt. Entfernung des Lösungsmittel und Überschichten des Rückstandes mit Diethylether lieferte das 2,4-Dimethyl-3,4-dihydro-2*H*-pyrimido[1,2-a]pyrimidin Hydroperchlorat, das abfiltriert und im Vakuum getrocknet wurde.
Ausbeute: 0,46 g
¹H-NMR (500 MHz, DMSO-d₆) [ppm] :
9,86 (s, 1H); 8,75 (dd, 1H); 8,55 (dd, 1H); 6,99 (dd, 1H); 4,43 (m, 1H); 3,76 (m, 1H); 2,29 (m, 1H); 1,69 (quar, 1H); 1,57 (d, 3H); 1,27 (d, 3H)

### 3. 2,4-Dimethyl-1,3,4,6,7,8-hexahydro-2H-pyrimido[1,2-a]pyrimidin

0,5 g 2,4-Dimethyl-3,4-dihydro-2*H*-pyrimido[1,2-a]pyrimidin Hydroperchlorat wurden in essigsaurer Lösung mit Palladium auf Aktivkohle 8 h unter H₂-Zufuhr erwärmt. Anschließende Filtration, Entfernen des Lösungsmittels und Zugabe von Diethylether lieferte das 2,4-Dimethyl-1,3,4,6,7,8-hexahydro-2*H-*pyrimido[1,2-a]pyrimidin Hydroacetat als farblose Kristalle, die aus Ethanol umkristallisiert wurden.
Ausbeute: 0,37 g
Fp. 101 °C
¹H-NMR (500 MHz, DMSO-d₆) [ppm] :
7,47 (s, 1H); 7,09 (s, 1H); 3,50-3,55 (m, 1H); 3,43-3,39 (m, 1H); 3,35-3,21 (m, 3H); 3,05-3,03 (m, 1H); 2,11 (m, 1H); 1,95-1,91 (m, 1H); 1,78-1,71 (m, 1H); 1,37-1,30 (quar, 1H); 1,24 (d, 3H); 1,14 (d, 3H)

Die Freisetzung des 2,4-Dimethyl-1,3,4,6,7,8-hexahydro-2*H-*pyrimido[1,2-a]pyrimidins erfolgte in alkalischer Ethanollösung.
Ausbeute: 0,1 g
Fp. 133 °C ¹H-NMR (500 MHz, DMSO-d₆) [ppm]:
3,24-3,16 (m, 3H); 3,16-3,14 (m, 1H); 3,09-2,93 (m, 1H); 2,86-2,83 (m, 1H); 1,89-1,85 (m, 1H); 1,77-1,73 (m, 1H); 1,65-1,58 (m, 1H); 1,17-1,10 (m, 4H); 0,97 (d, 3H)
MS: m/z = 167 [M]⁺

### Beispiel 3:

### 1. Benzimidazo[1,2-a]pyrimidin Hydroperchlorat

Die Herstellung erfolgte nach einer in der Literatur beschriebenen Methode (M. Künstlinger, E. Breitmaier, Synthesis 1983 (2), 161-162). Davon abweichend wurde das Produkt durch Zugabe von Perchlorsäure als Benzimidazo[1,2-a]pyrimidin Hydroperchlorat isoliert.
Fp. 245 °C
¹H-NMR (500 MHz, DMSO-d₆) [ppm]:
9,98 (dd, 1H); 9,26 (dd, 1H); 8,60 (d, 1H); 7,95 (d, 1H); 7,86-7,81 (m, 2H); 7,73 (t, 1H)

### 2. 1,2,3,4-Tetrahydro-benzimidazo[1,2-a]pyrimidin

0,602 g Benzimidazo[1,2-a]pyrimidin Hydroperchlorat wurden in salzsaurer Lösung (2 M HCl) mit Palladium auf Aktivkohle 9 h unter H₂-Zufuhr erwärmt. Anschließende Filtration, Entfernen des Lösungsmittels und Zugabe von Diethylether lieferte das 1,2,3,4-Tetrahydro-benzimidazo[1,2-a]pyrimidin Hydrochlorid als farblose Kristalle, die aus Ethanol umkristallisiert wurden.
Ausbeute: 0,18 g
Fp. 212 °C
¹H-NMR (500 MHz, DMSO-d₆) [ppm]:
12,62 (s, 1H); 9,18 (s, 1H); 7,47 (m, 1H); 7,38 (m, 1H); 7,27 (m, 1H); 4,08 (t, 2H); 3,48 (m, 2H); 2,14 (quint., 2H)
MS: m/z = 174 [M]⁺

Die Freisetzung des 1,2,3,4-Tetrahydro-benzimidazo[1,2-a]pyrimidins erfolgte in alkalischer Ethanollösung.
Fp. 190°C
¹H-NMR (500 MHz, DMSO-d₆) [ppm]:
7,13-7,07 (m, 3H); 6,92 (m, 1H); 6,85 (m, 1H); 3,96 (t, 2H); 3,31 (t, 2H); 2,03 (quint., 2H)
MS: m/z = 173 [M]⁺

### Allgemeine Synthese der Komplexe des Typs M₂L₄

MCl₄ (WCl₄, 1,00 g, 3,07 mmol), mindestens 2 Äquivalente des jeweiligen Liganden (9,21 mmol) und Kalium im Überschuss (ca. 1 g) werden in 50 mL THF zum Rückfluss erhitzt. Danach lässt man abkühlen und filtriert die Mutterlauge ab. Das Filtrat wird zur Trockene eingeengt und mit Toluol extrahiert. Das Produkt wird mit Hexan als brauner Feststoff gefällt, durch Filtration isoliert und im Hochvakuum getrocknet. Ausbeuten um 30%.

### Beispiel 4:

### Tetrakis[tetrahydro-imidazo[1,2-a]pyrimidinato]diwolfram-II

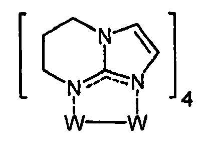

Synthese wie oben beschrieben mit 1,13g des Liganden 5,6,7,8-Tetrahydro-imidazo[1,2-a]pyrimidin.
¹H-NMR (500 MHz, C₆D₆) [ppm]:
6,7-6,2 (br, 2H); 3,8-3,3 (br, 4H); 1,9-1,3 (br, 2H).

### Beispiel 5:

### Tetrakis[dimethyl-1,3,4,6,7,8-hexahydro-2H-pyrimido-1,2-a]pyrimidinato]diwolfram-II

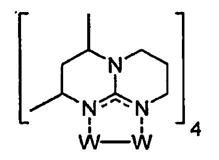

Synthese wie oben beschrieben mit 1,54g des Liganden 2,4-Dimethyl-1,3,4,6,7,8-hexahydro-2*H*-pyrimido-[1,2-*a*]pyrimidin.
¹H-NMR (500 MHz, C₆D₆) [ppm]:
3,5-2,6 (br, 4H); 2,0-1,3 (br, 4H); 1,3-0,9 (br, 6H).
ESI-MS: m/z = 184 [M⁺ + 3 OH].

### Beispiel 6:

### Tetrakis[tetrahydro-benzo[4,5]imidazo[1,2]a]pyrimidinato]diwolfram-II

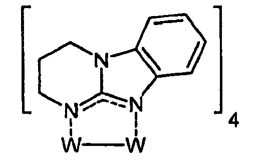

Synthese wie oben beschrieben mit 1,54g des Liganden 1,2,3,4-Tetrahydro-benzimidazo[1,2-a]pyrimidin.
In Abwandlung der allgemeinen Synthesevorschrift wird dieses Produkt aus der Mutterlauge mit Hexan gefällt. Der isolierte Feststoff ist nicht in Toluol löslich. ¹H-NMR (500 MHz, THF-d8) [ppm]:
6,60 (m, br, 1H); 6,55 (m, br, 1H); 6,40 (m, br, 1H); 6,34 (m, br, 1H); 3,72 (br, 2H); 3,42 (br, 2H); 1. 77 (br, 2H).

### Matrixmaterialien

In der vorliegenden Erfindung werden geeignete n-Dotanden für organische halbleitende Materialien wie Elektronentransportmaterialien beschrieben, wie sie üblicherweise in elektronischen Bauelementen, einschließlich optoelektronischen Bauelementen, wie beispielsweise OLEDs, Feldeffekttransistoren oder organischen Solarzellen, verwendet werden. Die halbleitenden Materialien sind vorzugsweise intrinsisch elektronenleitend.

Das Matrixmaterial kann teilweise (> 10 oder > 25 Gew.-%) oder im Wesentlichen (> 50 Gew.-% oder > 75 Gew.-%)) oder vollständig bestehen aus einem Metallphthalocyanin-Komplex, einem Buckminster-Fulleren, gegebenenfalls auch einem Porphyrin-Komplex, insbesondere Metallporphyrinkomplex, einer Oligothiophen-, Oligophenyl-, Oligophenylenvinylen- oder Oligofluoren-Verbindung, wobei das Oligomere vorzugsweise 2-500 oder mehr, vorzugsweise 2-100 oder 2-50 oder 2-10 monomere Einheiten umfasst. Gegebenenfalls kann das Oligomer auch > 4, > 6 oder > 10 oder mehr monomere Einheiten umfassen, insbesondere auch für die oben angegebenen Bereiche, also beispielsweise 4 oder 6-10 monomere Einheiten, 6 oder 10-100 monomere Einheiten oder 10-500 monomere Einheiten. Die Monomere bzw. Oligomere können substituiert oder unsubstituiert sein, wobei auch Block- oder Mischpolymerisate aus den genannten Oligomeren vorliegen können. Die Matrix kann auch eine Mischung von Oligomeren mit verschiedenen Kettenlängen sein, wie es für gewöhnliche Polymerschichten der Fall ist.

Das Matrixmaterial kann auch eine Verbindung mit einer Triarylamin-Einheit oder eine Spiro-Bifluoren-Verbindung sein. Die genannten Matrixmaterialien können auch in Kombination miteinander vorliegen, gegebenenfalls auch in Kombination mit anderen Matrixmaterialien. Die Matrixmaterialien können elektronenschiebende Substituenten wie Alkyl- oder Alkoxy-Reste aufweisen, die eine verminderte Ionisierungsenergie aufweisen oder die Ionisierungsenergie des Matrixmaterials vermindern.

Die als Matrixmaterial eingesetzten Metallphthalocyaninkomplexe oder Porphyrinkomplexe können ein Hauptgruppenmetallatom oder Nebengruppenmetallatom aufweisen. Das Metallatom Me kann jeweils 4-, 5- oder 6-fach koordiniert sein, beispielsweise in Form von Oxo- (Me=O), Dioxo- (O=Me=O), Imin-, Diimin-, Hydroxo-, Dihydroxo-, Amino- oder Diaminokomplexen, ohne hierauf beschränkt zu sein. Der Phthalocyaninkomplex oder Porphyrinkomplex kann jeweils teilweise hydriert sein, wobei jedoch vorzugsweise das mesomere Ringsystem nicht gestört wird. Die Phthalocyaninkomplexe können als Zentralatom beispielsweise Magnesium, Zink, Eisen, Nickel, Kobalt, Magnesium, Kupfer oder Vanadyl (= VO) enthalten. Die gleichen oder andere Metallatome bzw. Oxometallatome können im Falle von Porphyrinkomplexen vorliegen.

Als n-dotierbare Matrixmaterialen können auch eingesetzt werden Quinolinatokomplexe, beispielsweise des Aluminiums oder anderer Hauptgruppenmetalle, wobei die der Quinolinatoligand auch substituiert sein kann. Insbesondere kann das Matrixmaterial Tris(8-hydroxy-quinolinato)-aluminium sein. Auch andere Aluminiumkomplexe mit O und/oder N Donoratomen können gegebenenfalls eingesetzt werden.

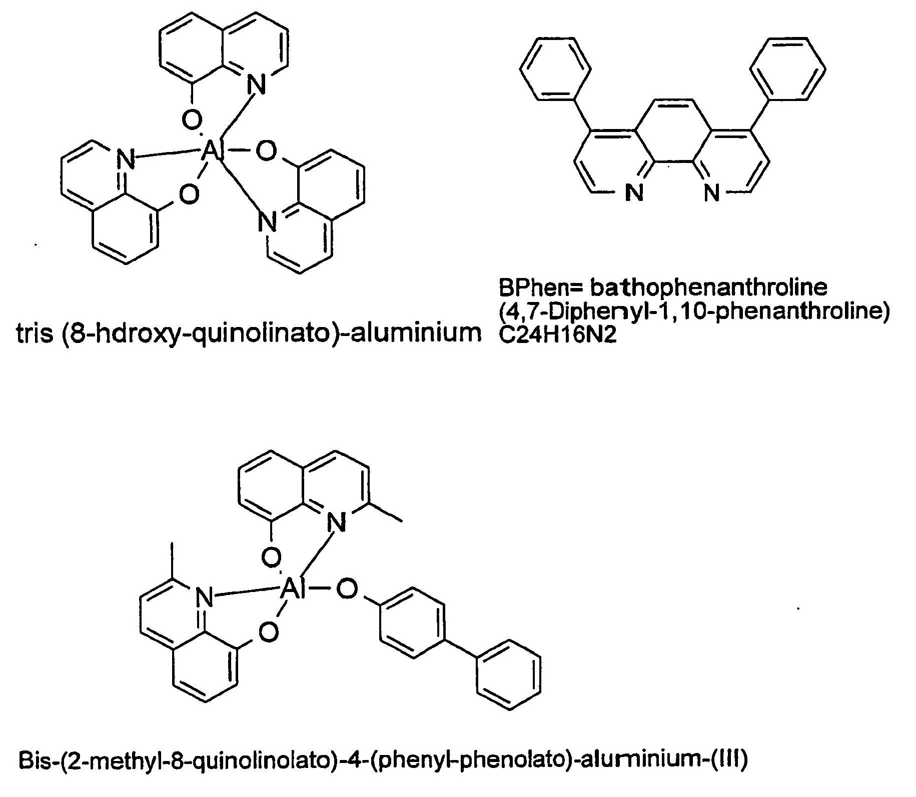

Die Quinolinatokomplexe können beispielsweise einen, zwei oder drei Quinolinatoliganden enthalten, wobei die anderen Liganden vorzugsweise mit O und/oder N-Donoratomen an das Zentralatom komplexieren, wie beispielsweise obenstehender Al-Komplex.

Als Matrixmaterial können auch Phenanthroline eingesetzt werden, die substituiert oder unsubstituiert sein können, insbesondere Aryl-substituiert, beispielsweise Phenyl- oder Naphthyl-substituiert. Insbesondere kann Bphen als Matrixmaterial eingesetzt werden.

Als Matrixmaterial können auch Heteroaromaten wie insbesondere Triazole eingesetzt werden, gegebenenfalls auch Pyrrole, Imidazole, Triazole, Pyridine, Pyrimidine, Pyridazine und dergleichen. Die Heteroaromaten sind vorzugsweise substituiert, insbesondere Aryl-substituiert, beispielsweise Phenyl- oder Naphthyl-substituiert. Insbesondere kann untenstehendes Triazol als Matrixmaterial eingesetzt werden.

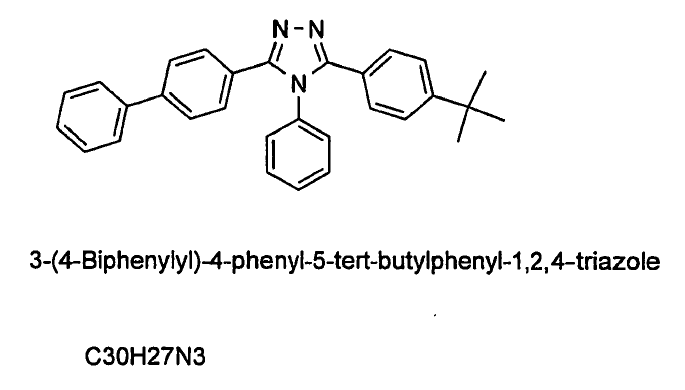

Vorzugsweise besteht das verwendete Matrixmaterial vollständig aus einem Metallphthalocyanin-Komplex, insbesondere ZnPc, einem Porphyrin-Komplex, oder einem Buckminster-Fulleren, insbesondere Fulleren C60.

Es versteht sich, dass die genannten Matrixmaterialien auch untereinander oder mit anderen Materialien gemischt im Rahmen der Erfindung einsetzbar sind. Es versteht sich, dass auch geeignete andere organische Matrixmaterialien verwendet werden können, die halbleitende Eigenschaften aufweisen.

### Dotierungskonzentration

Die Erfindung betrifft ferner ein organisches halbleitendes Material enthaltend einen Metallkomplex als n-Dotanden. Vorzugsweise liegt der Dotand in einer Dotierungskonzentration von ≤ 1:1 zu dem Matrixmolekül bzw. der monomeren Einheit eines polymeren Matrixmoleküls vor, vorzugsweise in einer Dotierungskonzentration von 1:2 oder kleiner, besonders bevorzugt von 1:5 oder kleiner oder 1:10 oder kleiner. Die Dotierungskonzentration kann in dem Bereich von 1:1 bis 1:100.000 oder kleiner, insbesondere in dem Bereich von 1:5 bis 10.000 oder 1:10 bis 1.000 liegen, beispielsweise in dem Bereich von 1:10 bis 1:100 oder 1:25 bis 1:50, ohne hierauf beschränkt zu sein.

### Durchführung der Dotierung

Die Dotierung des jeweiligen Matrixmaterials mit den erfindungsgemäß zu verwendenden n-Dotanden kann durch eines oder eine Kombination der folgenden Verfahren hergestellt wird:
a) Mischverdampfung im Vakuum mit einer Quelle für das Matrixmaterial und einer für den Dotanden.
b) Sequentielles Deponieren des Matrixmaterials und des n-Dotanden auf einem Substrat mit anschliessender Eindiffusion des Dotanden, insbesondere durch thermische Behandlung
c) Dotierung einer Matrixschicht durch eine Lösung von n-Dotanden mit anschliessendem Verdampfen des Lösungsmittels, insbesondere durch thermische Behandlung
d) Oberflächendotierung einer Matrixmaterialschicht durch eine oberflächlich aufgebrachte Schicht von Dotanden
e) Herstellung einer Lösung von Matrixmolekülen und Dotanden und anschließende Herstellung einer Schicht aus dieser Lösung mittels konventioneller Methoden wie beispielsweise Verdampfen des Lösungsmittels oder Aufschleudern

Die Dotierung kann gegebenenfalls auch derart erfolgen, dass der Dotand aus einer Precursor-Verbindung heraus verdampft wird, die beim Erhitzen und/oder Bestrahlung den Dotanden freisetzt. Als Precursor-Verbindung kann beispielsweise jeweils eine Carbonylverbindung, Distickstoffverbindung oder dergleichen eingesetzt werden, die bei der Freisetzung des Dotanden CO, Stickstoff oder dergleichen abspalten, wobei auch andere geeignete Precursor einsetzbar sind, wie beispielsweise Salze, z.B. Halogenide, oder dergleichen. Die Bestrahlung kann mittels elektromagnetischer Strahlung, insbesondere sichtbarem Licht, UV-Licht oder IR-Licht erfolgen, beispielsweise jeweils Laserlicht, oder auch durch andere Strahlungsarten. Durch die Bestrahlung kann im wesentlichen die zur Verdampfung notwendige Wärme bereitgestellt werden, es kann auch gezielt in bestimmte Banden der zu verdampfenden Verbindungen bzw. Precursor oder Verbindungskomplexe wie Charge-Transfer-Komplexe eingestrahlt werden, um beispielsweise durch Überführung in angeregte Zustände die Verdampfung der Verbindungen durch Dissoziation der Komplexe zu erleichtern. Der Komplex kann aber insbesondere auch ausreichend stabil sein, um unter den gegebenen Bedingungen undissoziiert zu verdampfen oder auf das Substrat aufgebracht zu werden. Es versteht sich, dass auch andere geeignete Verfahren zur Durchführung der Dotierung eingesetzt werden können.

Auf diese Weise können somit erfindungsgemäß n-dotierte Schichten von organischen Halbleitern hergestellt werden, die vielfältig einsetzbar sind.

### Halbleitende Schicht

Mittels der erfindungsgemäß verwendeten Metallkomplexe können halbleitende Schichten erzeugt werden, die gegebenenfalls aber auch linienförmig ausgebildet sind, wie z.B. als Leitfähigkeitspfade, Kontakte oder dergleichen. Die Metallkomplexe können hierbei als n-Dotanden zusammen mit einer anderen Verbindung, die als Matrixmaterial fungieren kann, eingesetzt werden, wobei das Dotierungsverhältns 1 : 1 oder kleiner sein kann. Der erfindungsgemäß verwendete Metallkomplexe kann zu der jeweils anderen Verbindung bzw. Komponente aber auch in höheren Anteilen vorliegen, so dass das Verhältnis Metallkomplex : Verbindung im Verhältnis > 1 : 1 liegen kann, beispielsweise im Verhältnis ≥ 2 : 1, ≥ 5 : 1, ≥ 10 : 1 oder ≥ 20 : 1 oder höher. Die jeweils andere Komponente kann eine solche sein, wie sie als Matrixmaterial im Falle der Herstellung dotierter Schichten eingesetzt werden kann, ohne hierauf beschränkt zu sein. Gegebenenfalls kann der erfindungsgemäß verwendete Metallkomplex auch im wesentlich in reiner Form vorliegen, beispielsweise als reine Schicht.

Der einen Metallkomplex enthaltende oder im wesentlichen oder vollständig aus diesem bestehende Bereich kann insbesondere mit einem organischen halbleitenden Material und/oder einem anorganischen halbleitenden Material elektrisch stromleitend kontaktiert sein, beispielsweise auf einem derartigen Substrat angeordnet sein.

Vorzugsweise werden die genannten Metallkomplexe erfindungsgemäß als n-Dotanden eingesetzt, z.B. in einem Verhältnis ≤ 1 : 1 oder ≤ 1 : 2, oder wie weiter oben näher ausgeführt. Mittels der erfindungsgemäß als n-Dotanden eingesetzten Metallkomplexen können beispielsweise bei der Verwendung von Fulleren C₆₀ als Matrix halbleitende Schichten mit Leitfähigkeiten bei Raumtemperatur in dem Bereich von 10⁻⁵ S/cm oder höher erzielt werden, beispielsweise von 10⁻³ S/cm oder höher, beispielsweise von 10⁻¹ S/cm. Bei der Verwendung von Phthalocyanin-Zink als Matrix wurde eine Leitfähigkeit von höher 10⁻⁸ S/cm erzielt, beispielsweise 10⁻⁶ S/cm. Bisher war es nicht möglich, diese Matrix mit organischen Donoren zu dotieren, da das Reduktionspotential der Matrix zu gering ist. Die Leitfähigkeit von undotiertem Phthalocyanin Zink beträgt hingegen maximal 10⁻¹⁰ S/cm.

Es versteht sich, dass die Schicht oder das Gebilde mit Metallkomplex jeweils einen oder mehrere verschiedene derartige Komplexe enthalten kann.

### Elektronisches Bauelement

Unter Verwendung der organischen Verbindungen zur Herstellung n-dotierter organischer halbleitender Materialien, die insbesondere in Form von Schichten oder elektrischen Leitungspfaden angeordnet sein können, können eine Vielzahl elektronischer Bauelemente oder diese enthaltende Einrichtungen mit einer n-dotierten organischen Halbleiterschicht hergestellt sein, die somit von der Erfindung mit umfasst werden. Im Sinne der Erfindung werden von dem Begriff "elektronische Bauelemente" auch optoelektronische Bauelemente mit umfasst. Durch die erfindungsgemäßen Verbindungen können die elektronischen Eigenschaften eines elektronisch funktionell wirksamen Bereichs des Bauelementes wie dessen elektrische Leitfähigkeit, lichtemittierende Eigenschaften oder dergleichen vorteilhaft verändert werden. So kann durch die Metallkomplexe als n-Dotanden die Leitfähigkeit der dotierten Schichten und/oder die Verbesserung der Ladungsträgerinjektion von Kontakten in die dotierte Schicht verbessert werden.

Die Erfindung umfasst insbesondere organische lichtemittierende Dioden (OLED), organische Solarzellen, organische Dioden, insbesondere solche mit hohem Gleichrichtungsverhältnis wie 10³-10⁷, vorzugsweise 10⁴-10⁷ oder 10⁵-10⁷, und organischen Feldeffekttransistoren, die mittels der neutralen Metallkomplexe nach der Erfindung hergestellt sind.

In dem elektronischen Bauelement kann eine erfindungsgemäß n-dotierte Schicht auf Basis eines organischen Matrixmaterials beispielsweise in folgenden Schichtstrukturen vorliegen, wobei vorzugsweise die Basismaterialien oder Matrixmaterialien der einzelnen Schichten jeweils organisch sind:
M-i-n: Metall-Isolator-n-dotierter Halbleiter, wobei die Schicht M den Metallgrundkontakt bildet und beispielsweise ITO, Au, Ag, Al usw. sein kann. Der Deckkontakt bildet mit der n-dotierten Schicht einen ohmschen Kontakt und kann beispielsweise aus Al bestehen. Die Schicht "i" steht für eine undotierte Schicht.
n-i-M: es gelten die Ausführungen zur M-i-n Struktur, im Unterschied hierzu ist jedoch der ohmsche Kontakt auf dem Substrat vorgesehen.
p-i-n: p-dotierter Halbleiter-Isolator-n-dotierter Halbleiter, n-i-p: n-dotierter Halbleiter-Isolator-p-dotierter Halbleiter, "i" ist wiederum eine undotierte Schicht, "p" ist eine p-dotierte Schicht. Die Kontaktmaterialien sind hier löcherinjizierend, wobei p-seitig beispielsweise eine Schicht oder ein Kontakt aus ITO oder Au vorgesehen sein kann, oder elektroneninjizierend, wobei n-seitig eine Schicht oder ein Kontakt aus ITO, Al oder Ag vorgesehen sein kann.

In obigen Strukturen kann im Bedarfsfall auch die i-Schicht ausgelassen werden, wodurch Schichtenabfolgen mit p-n oder n-p-Übergängen erhalten werden können.

Die Verwendung der Dotanden ist jedoch auf die oben genannten Ausführungsbeispiele nicht beschränkt, insbesondere können die Schichtstrukturen durch Einführung zusätzlicher geeigneter Schichten ergänzt bzw. modifiziert werden. Insbesondere können jeweils OLEDs mit derartigen Schichtabfolgen, insbesondere mit pin- oder mit einer dazu inversen Struktur, mit erfindungsgemäßen n-Dotanden aufgebaut werden.

Mit Hilfe der erfindungsgemäßen n-Dotanden können insbesondere organische Dioden vom Typ Metall-Isolator-n-dotierte Halbleiter (min) oder auch gegebenenfalls vom pin-Typ hergestellt werden, beispielsweise auf der Basis von Phthalocyanin-Zink. Diese Dioden zeigen ein Rektifizierungsverhältnis von 10⁵ und höher. Ferner können unter Verwendung der Dotanden elektronische Bauelemente mit p-n-Übergängen erzeugt werden, wobei für die p- und die n-dotierte Seite jeweils dasselbe Halbleitermaterial verwendet wird (Homo-p-n-Übergang) und wobei für das n-dotierte Halbleitermaterial ein erfindungsgemäßer Metallkomplex eingesetzt wird. Derartige Bauteile sind von der Erfindung somit mit umfasst.

Die Metallkomplexe können erfindungsgemäß in den elektronischen Bauelementen aber auch in Schichten, Leitfähigkeit spfaden, Punktkontakten oder dergleichen eingesetzt werden, wenn diese gegenüber einer anderen Komponente überwiegen, beispielsweise als Injektionsschicht in reiner oder im wesentlichen reiner Form.

### Anwendungsbeispiele

Es wird ein elektronenreicher neutraler Metallkomplex bereitgestellt.

Der vorgelegte Metallkomplex wird gleichzeitig mit dem Matrixmaterial verdampft. Gemäß dem Ausführungsbeispiel ist das Matrixmaterial jeweils Phthalocyanin-Zink oder Fulleren C₆₀. Der N-Dotand und Matrixmaterial können derart verdampft werden, dass die auf einem Substrat in einer Vakuumverdampfungsanlage niedergeschlagene Schicht ein Dotierungsverhältnis von n-Dotand zu Matrixmaterial von 1:10 aufweist.

Die jeweils mit dem n-Dotanden dotierte Schicht des organischen Halbleitermaterials ist auf einer ITO-Schicht (Indiumzinnoxid) aufgebracht, welche auf einem Glassubstrat angeordnet ist. Nach Aufbringung der n-dotierten organischen Halbleiterschicht wird eine Metallkathode aufgebracht, beispielsweise durch Aufdampfung eines geeigneten Metalls, um eine organische Leuchtdiode herzustellen. Es versteht sich, dass die organische Leuchtdiode auch einen sogenannten invertierten Schichtaufbau haben kann, wobei die Schichtenabfolge ist: Glassubstrat - Metallkathode -n-dotierte organische Schicht - transparente leitende Deckschicht (beispielsweise ITO). Es versteht sich, dass je nach Anwendungsfall zwischen den einzelnen genannten Schichten weitere Schichten vorgesehen sein können.

### Beispiel 1:

Eine Schicht aus Zink-Phthalocyanin (ZnPc) wurde mit dem Metallkomplex [Cr2(hpp)4] dotiert. Die dotierte Schicht wurde durch Mischverdampfung der ZnPc-Matrix und des Dotanden Cr2(hpp)4 im Hochvakuum hergestellt. Die Konzentration des Dotanden in der Matrix betrug 1.9 mol%. Die Sublimationstemperatur des Dotanden betrug 160°C. Die dotierte Schicht zeigte eine hohe Leitfähigkeit von 4*10^-6 S/cm. Durch Ausheizen der Schicht bei 70°C ließ sich die Leitfähigkeit auf 6*10^-5 S/cm steigern. Die Aktivierungsenergie der Leitfähigkeit betrug 0.27 eV.

## Patentansprüche

1. Verwendung eines Metallkomplexes als Dotand zur Dotierung eines organischen halbleitenden Matrixmaterials zur Veränderung der elektrischen Eigenschaften desselben, wobei der Metallkomplex bezüglich des Matrixmaterials einen n-Dotanden darstellt, oder Verwendung eines Metallkomplexes zur Herstellung eines elektronischen Bauelementes mit einem den Metallkomplex enthaltenden, elektronisch funktionell wirksamen Bereich, wobei der Metallkomplex ein neutraler elektronenreicher Metallkomplex der Formel 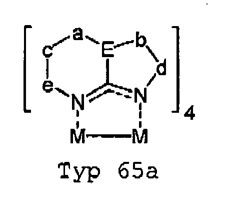 ist, wobei
- die Strukturelemente a-e die Bedeutung: a = -CR₁R₂-, b = -CR₃R₄-, c = -CR₅R₆-, d = -CR₇R₈- und e = -CR₉R₁₀- haben können, wobei R₁, R₂, R₃, R₄, R₅, R₆, R₇, R₈, R₉ und R₁₀ gleichzeitig oder unabhängig voneinander H, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sind, vorzugsweise sind R₁, R₃, R₅, R₇, R₉ = H und R₂, R₄, R₆, R₈, R₁₀ = Alkyl mit C₁-C₂₀, Cycloalkyl mit C₁-C₂₀, Alkenyl mit C₁-C₂₀, Alkinyl mit C₁-C₂₀, Aryl, Heteroaryl, -NR₂ oder -OR, oder
- wahlweise a oder b oder e oder d NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und d oder b und e NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- bei c C durch Si ersetzt ist,
- wobei die Bindungen b-d und c-e oder b-d und a-c gleichzeitig oder unabhängig voneinander ungesättigt sein können,
- wobei die Bindungen b-d, a-c und c-e gleichzeitig oder unabhängig voneinander Teil eines gesättigten oder ungesättigten Ringsystems sein können, welches auch die Heteroelemente O, S, Se, N, P, Si, Ge, Sn enthalten kann, oder
- wobei die Bindungen b-d, a-c und c-e gleichzeitig oder unabhängig voneinander Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente 0, S, Se, N, enthalten kann,
- wobei das Metall M ein Übergangsmetall ist, vorzugsweise W oder Mo; 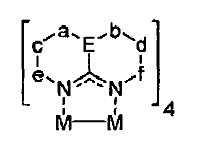 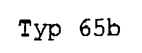 wobei
- die Strukturelemente a-f die Bedeutung: a= -CR₁R₂-, b = -CR₃R₄-, c = -CR₅R₆-, d = -CR₇R₈-, e = -CR₉R₁₀- und f = CR₁₁R₁₂ haben können, wobei R₁, R₂, R₃, R₄, R₅, R₆, R₇, R₈, R₉, R₁₀, R₁₁ und R₁₂ Wasserstoff, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sind, vorzugsweise sind R₁, R₃, R₅, R₇, R₉, R₁₁ = H und R₂, R₉, R₆, R₈, R₁₀, R₁₂ = Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR, oder
- bei den Strukturelementen c und/oder d C durch Si ersetzt sein kann, oder
- wahlweise a oder b oder e oder f NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und f oder b und e NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, b-d, c-e und d-f, aber nicht gleichzeitig a-c und c-e und nicht gleichzeitig b-d und d-f ungesättigt sein können,
- wobei die Bindungen a-c, b-d, c-e und d-f Teil eines gesättigten oder ungesättigten Ringsystems sein können, welches auch die Heteroelemente O, S, Se, N, P, Si, Ge, Sn enthalten kann, oder
- die Bindungen a-c, b-d, c-e und d-f Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente 0, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann,
- wobei das Metall M ein Übergangsmetall, vorzugsweise W oder Mo ist; 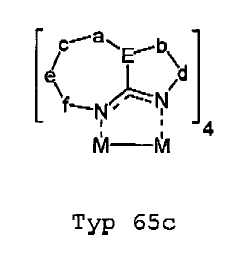 wobei
- die Strukturelemente a-f die Bedeutung: a = -CR₁R₂-, b = -CR₃R₄-, c = -CR₅R₆-, d = -CR₇R₈-, e = -CR₉R₁₀- und f = CR₁₁R₁₂ haben können, wobei R₁, R₂, R₃, R₄, R₅, R₆, R₇, R₈, R₉, R₁₀, R₁₁ und R₁₂ gleichzeitig oder unabhängig voneinander H, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sein kann; vorzugsweise ist R₁, R₃, R₅, R₇, R₉, R₁₁ = H und R₂, R₄, R₆, R₈, R₁₀, R₁₂ = Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR, oder
- bei c oder e C durch Si ersetzt sein kann, oder
- wahlweise a oder b oder d oder f NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und d oder b und f NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, c-e, e-f und b-d, aber nicht gleichzeitig a-c, c-e und e-f und nicht gleichzeitig a-c und c-e und nicht gleichzeitig c-e und e-f ungesättigt sein können,
- wobei die Bindungen a-c, c-e, e-f und b-d Teil eines gesättigten oder ungesättigten Ringsystems sein können, welches auch die Heteroelemente O, S, Se, N, P, Si, Ge, Sn enthalten kann, oder
- die Bindungen a-c, c-e, e-f und b-d Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente 0, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann,
- wobei das Metall M ein Übergangsmetall ist, vorzugsweise W oder Mo; oder 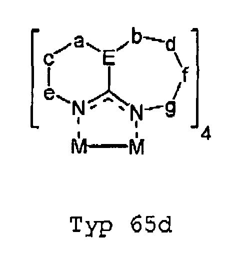
- wobei die Strukturelemente a-g die Bedeutung: a = - CR₁R₂-, b = -CR₃R₄-, c = -CR₅R₆-, d = -CR₇R₈-, e = -CR₉R₁₀-, f = CR₁₁R₁₂ und g = CR₁₃R₁₄ haben können, wobei R₁, R₂, R₃, R₄, R₅, R₆, R₇, R₈, R₉, R₁₀, R₁₁, R₁₂, R₁₃ und R₁₄ gleichzeitig oder unabhängig voneinander H, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sein kann; vorzugsweise ist R₁, R₃, R₅, R₇, R₉, R₁₁, R₁₃ = H und R₂, R₄, R₆, R₈, R₁₀, R₁₂, R₁₄ = Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR, oder
- bei c, d und f, jedoch nicht d und f gleichzeitig, C durch Si ersetzt sein kann, oder
- wahlweise a oder b oder e oder g NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und g oder b und e NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, c-e, b-d, d-f und f-g, aber nicht gleichzeitig a-c und c-e, und nicht gleichzeitig b-d, d-f und f-g, und nicht gleichzeitig b-d und d-f, und nicht gleichzeitig d-f und f-g, ungesättigt sein können,
- wobei die Bindungen a-c, c-e, b-d, d-f und f-g Teil eines gesättigten oder ungesättigten Ringsystems sein können, welches auch die Heteroelemente O, S, Se, N, P, Si, Ge, Sn enthalten kann, oder
- die Bindungen a-c, c-e, b-d, d-f und f-g Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente 0, S, Se, N, enthalten kann
- wobei das Metall M ein Übergangsmetall ist, vorzugsweise W oder Mo.

2. Elektronisches Bauelement mit einem elektronisch funktionell wirksamen Bereich, **dadurch gekennzei chnet**, **dass** der elektronisch wirksame Bereich zumindest einen oder mehrere neutrale Metallkomplexe der Formel 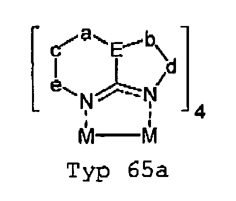 ist, wobei
- die Strukturelemente a-e die Bedeutung: a = -CR₁R₂-, b = -CR₃R₄-, c = -CR₅R₆-, d = -CR₇R₈- und e = -CR₉R₁₀- haben können, wobei R₁, R₂, R₃, R₄, R₅, R₆, R₇, R₈, R₉ und R₁₀ gleichzeitig oder unabhängig voneinander H, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sind, vorzugsweise sind R₁, R₃, R₅, R₇, R₉ = H und R₂, R₄, R₆, R₈, R₁₀ = Alkyl mit C₁-C₂₀, Cycloalkyl mit C₁-C₂₀, Alkenyl mit C₁-C₂₀, Alkinyl mit C₁-C₂₀, Aryl, Heteroaryl, -NR₂ oder -OR, oder
- wahlweise a oder b oder e oder d NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und d oder b und e NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- bei c C durch Si ersetzt ist,
- wobei die Bindungen b-d und c-e oder b-d und a-c gleichzeitig oder unabhängig voneinander ungesättigt sein können,
- wobei die Bindungen b-d, a-c und c-e gleichzeitig oder unabhängig voneinander Teil eines gesättigten oder ungesättigten Ringsystems sein können, welches auch die Heteroelemente O, S, Se, N, P, Si, Ge, Sn enthalten kann, oder
- wobei die Bindungen b-d, a-c und c-e gleichzeitig oder unabhängig voneinander Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann,
- wobei das Metall M ein Übergangsmetall ist, vorzugsweise W oder Mo; 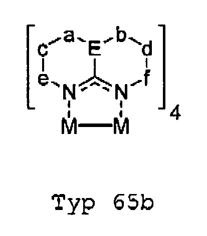 wobei
- die Strukturelemente a-f die Bedeutung: a= -CR₁R₂-, b = -CR₃R₄-, c = -CR₅R₆-, d = -CR₇R₈-, e = -CR₉R₁₀- und f = CR₁₁R₁₂ haben können, wobei R₁, R₂, R₃, R₄, R₅, R₆, R₇, R₈, R₉, R₁₀, R₁₁ und R₁₂ Wasserstoff, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sind, vorzugsweise sind R₁, R₃, R₅, R₇, R₉, R₁₁ = H und R₂, R₄, R₆, R₈, R₁₀, R₁₂ = Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR, oder
- bei den Strukturelementen c und/oder d C durch Si ersetzt sein kann, oder
- wahlweise a oder b oder e oder f NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und f oder b und e NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, b-d, c-e und d-f, aber nicht gleichzeitig a-c und c-e und nicht gleichzeitig b-d und d-f ungesättigt sein können,
- wobei die Bindungen a-c, b-d, c-e und d-f Teil eines gesättigten oder ungesättigten Ringsystems sein können, welches auch die Heteroelemente 0, S, Se, N, P, Si, Ge, Sn enthalten kann, oder
- die Bindungen a-c, b-d, c-e und d-f Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann,
- wobei das Metall M ein Übergangsmetall, vorzugsweise W oder Mo ist; 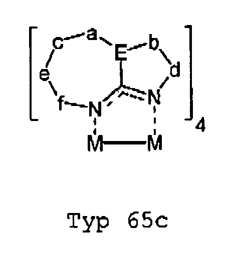 wobei
- die Strukturelemente a-f die Bedeutung: a = -CR₁R₂-, b = -CR₃R₄-, c = -CR₅R₆-, d = -CR₇R₈-, e = -CR₉R₁₀- und f = CR₁₁R₁₂ haben können, wobei R₁, R₂, R₃, R₄, R₅, R₆, R₇, R₈, R₉, R₁₀, R₁₁ und R₁₂ gleichzeitig oder unabhängig voneinander H, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sein kann; vorzugsweise ist R₁, R₃, R₅, R₇, R₉, R₁₁ = H und R₂, R₄, R₆, R₈, R₁₀, R₁₂ = Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR, oder
- bei c oder e C durch Si ersetzt sein kann, oder
- wahlweise a oder b oder d oder f NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und d oder b und f NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, c-e, e-f und b-d, aber nicht gleichzeitig a-c, c-e und e-f und nicht gleichzeitig a-c und c-e und nicht gleichzeitig c-e und e-f ungesättigt sein können,
- wobei die Bindungen a-c, c-e, e-f und b-d Teil eines gesättigten oder ungesättigten Ringsystems sein können, welches auch die Heteroelemente O, S, Se, N, P, Si, Ge, Sn enthalten kann, oder
- die Bindungen a-c, c-e, e-f und b-d Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann,
- wobei das Metall M ein Übergangsmetall ist, vorzugsweise W oder Mo; oder 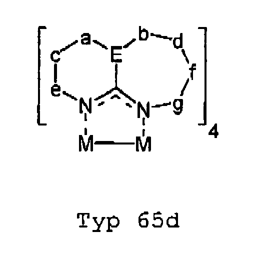
- wobei die Strukturelemente a-g die Bedeutung: a = -CR₁R₂-, b = -CR₃R₄-, c = -CR₅R₆-, d = -CR₇R₈-, e = -CR₉R₁₀-, f = CR₁₁R₁₂ und g = CR₁₃R₁₄ haben können, wobei R₁, R₂, R₃, R₄, R₅, R₆, R₇, R₈, R₉, R₁₀, R₁₁, R₁₂, R₁₃ und R₁₄ gleichzeitig oder unabhängig voneinander H, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sein kann; vorzugsweise ist R₁, R₃, R₅, R₇, R₉, R₁₁, R₁₃ = H und R₂, R₄, R₆, R₈, R₁₀, R₁₂, R₁₄ = Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR, oder
- bei c, d und f, jedoch nicht d und f gleichzeitig, C durch Si ersetzt sein kann, oder
- wahlweise a oder b oder e oder g NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und g oder b und e NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, c--e, b-d, d-f und f-g, aber nicht gleichzeitig a-c und c-e, und nicht gleichzeitig b-d, d-f und f-g, und nicht gleichzeitig b-d und d-f, und nicht gleichzeitig d-f und f-g, ungesättigt sein können,
- wobei die Bindungen a-c, c-e, b-d, d-f und f-g Teil eines gesättigten oder ungesättigten Ringsystems sein können, welches auch die Heteroelemente O, S, Se, N, P, Si, Ge, Sn enthalten kann, oder
- die Bindungen a-c, c-e, b-d, d-f und f-g Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente 0, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann
- wobei das Metall M ein Übergangsmetall ist, vorzugsweise W oder Mo.

3. Elektronisches Bauelement nach Anspruch 2, **dadurch gekennnzeichnet, dass** der elektronisch wirksame Bereich ein organisches halbleitendes Matrixmaterial aufweist, welches mit dem zumindest einen oder mehreren neutralen Metallkomplexen als n-Dotand dotiert ist.

4. Elektronisches Bauelement nach Anspruch 2 oder 3, in Form einer organischen lichtemittierenden Diode (OLED), einer photovoltaischen Zelle, einer organischen Solarzelle, einer organischen Diode oder eines organischen Feldeffekttransistors, bei dem das mit dem zumindest einen oder mehreren neutralen Metallkomplexen dotierte halbleitende organisches Material einen elektronisch funktionell wirksamen Metall des elektronischen Bauelements darstellt.

## Claims

1. Use of a metal complex as a dopant for doping an organic semiconducting matrix material in order to alter the latter's electrical characteristics, wherein the metal complex constitutes an n-dopant with regard to the matrix material, or the use of a metal complex to produce an electronic device with an electronically functionally effective region containing the metal complex, wherein the metal complex is a neutral electron-rich metal complex with formula 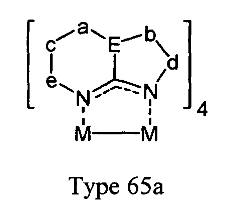 wherein
- the structural elements a-e may mean: a = -CR₁R₂-, b = -CR₃R₄-, c = -CR₅R₆-, d = -CR₇R₈- and e = -CR₉R₁₀-, where R₁, R₂, R₃, R₄, R₅, R₆, R₇, R₈, R₉ and R₁₀ are, at the same time or independently of one another, H, C₁-C₂₀ alkyl, C₁-C₂₀ cycloalkyl, C₁-C₂₀ alkenyl, C₁-C₂₀ alkinyl, aryl, heteroaryl, - NR₂ or -OR, preferably R₁, R₃, R₅, R₇, R₉ = H and R₂, R₄, R₆, R₈, R₁₀ = C₁-C₂₀ alkyl, C₁-C₂₀ cycloalkyl, C₁-C₂₀ alkenyl, C₁-C₂₀ alkinyl, aryl, heteroaryl, -NR₂ or -OR, or
- optionally, a or b or e or d may be NR with R = C₁-C₂₀ alkyl, C₁-C₂₀ cycloalkyl, C₁-C₂₀ alkenyl, C₁-C₂₀ alkinyl, aryl, heteroaryl, or
- optionally, a and d or b and e may be NR with R = C₁-C₂₀ alkyl, C₁-C₂₀ cycloalkyl, C₁-C₂₀ alkenyl, C₁-C₂₀ alkinyl, aryl, heteroaryl, or
- at c, C is replaced by Si,
- wherein the bonds b-d and c-e or b-d and a-c can, at the same time or independently of one another, be unsaturated,
- wherein the bonds b-d, a-c and c-e can, at the same time or independently of one another, be part of a saturated or unsaturated ring system which may also contain the heteroelements O, S, Se, N, P, Si, Ge, Sn, or
- wherein the bonds b-d, a-c and c-e can, at the same time or independently of one another, be part of an aromatic or condensed aromatic ring system which may also contain the heteroelements O, S, Se, N,
- wherein the atom E is an element from the main group, preferably selected from the group N, P, As, Sb, though without being limited to these,
- wherein the structural element a-E-b may optionally be a component of a saturated or unsaturated ring system which may also contain the heteroelements O, S, Se, N, P, Si, Ge, Sn, or
- the structural element a-E-b may optionally be a component of an aromatic ring system which may also contain the heteroelements O, S, Se, N, ,
- wherein the metal M is a transition metal, preferably W or Mo; 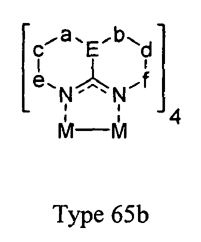
wherein
- the structural elements a-f may mean: a = -CR₁R₂-, b = -CR₃R₄-, c = -CR₅R₆-, d = -CR₇R₈-, e = -CR₉R₁₀- and f = CR₁₁R₁₂, where R₁, R₂, R₃, R₄, R₅, R₆, R₇, R₈, R₉, R₁₀, R₁₁ and R₁₂ are hydrogen, C₁-C₂₀ alkyl, C₁-C₂₀ cycloalkyl, C₁-C₂₀ alkenyl, C₁-C₂₀ alkinyl, aryl, heteroaryl, - NR₂ or -OR, preferably R₁, R₃, R₅, R₇, R₉, R₁₁ = H and R₂, R₄, R₆, R₈, R₁₀, R₁₂ = C₁-C₂₀ alkyl, C₁-C₂₀ cycloalkyl, C₁-C₂₀ alkenyl, C₁-C₂₀ alkinyl, aryl, heteroaryl, - NR₂ or -OR, or
- in the structural elements c and/or d, C may be replaced by Si, or
- optionally, a or b or e or f may be NR with R = C₁-C₂₀ alkyl, C₁-C₂₀ cycloalkyl, C₁-C₂₀ alkenyl, C₁-C₂₀ alkinyl, aryl, heteroaryl, or
- optionally, a and f or b and e may be NR with R = C₁-C₂₀ alkyl, C₁-C₂₀ cycloalkyl, C₁-C₂₀ alkenyl, C₁-C₂₀ alkinyl, aryl, heteroaryl,
- wherein the bonds a-c, b-d, c-e and d-f, but not simultaneously a-c and c-e and not simultaneously b-d and d-f may be unsaturated,
- wherein the bonds a-c, b-d, c-e and d-f can be part of a saturated or unsaturated ring system which may also contain the heteroelements O, S, Se, N, P, Si, Ge, Sn, or
- the bonds a-c, b-d, c-e and d-f may be part of an aromatic or condensed aromatic ring system which may also contain the heteroelements O, S, Se, N,
- wherein the atom E is an element from the main group, preferably selected from the group N, P, As, Sb, though without being limited to these,
- wherein the structural element a-E-b may optionally be a component of a saturated or unsaturated ring system which may also contain the heteroelements O, S, Se, N, P, Si, Ge, Sn, or
- the structural element a-E-b may optionally be a component of an aromatic ring system which may also contain the heteroelements O, S, Se, N,
- wherein the metal M is a transition metal, preferably W or Mo; 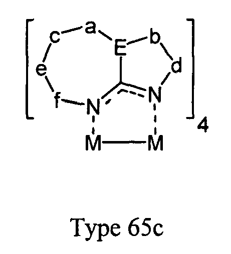
wherein
- the structural elements a-f may mean: a = -CR₁R₂-, b = -CR₃R₄-, c = -CR₅R₆-, d = -CR₇R₈-, e = -CR₉R₁₀- and f = CR₁₁R₁₂, where R₁, R₂, R₃, R₄, R₅, R₆, R₇, R₈, R₉, R₁₀, R₁₁ and R₁₂ can, at the same time or independently from one another, be H, C₁-C₂₀ alkyl, C₁-C₂₀ cycloalkyl, C₁-C₂₀ alkenyl, C₁-C₂₀ alkinyl, aryl, heteroaryl, - NR₂ or -OR, preferably R₁, R₃, R₅, R₇, R₉, R₁₁ = H and R₂, R₄, R₆, R₈, R₁₀, R₁₂ = C₁-C₂₀ alkyl, C₁-C₂₀ cycloalkyl, C₁-C₂₀ alkenyl, C₁-C₂₀ alkinyl, aryl, heteroaryl, - NR₂ or -OR, or
- at c or e, C may be replaced by Si, or
- optionally, a or b or d or f may be NR with R = C₁-C₂₀ alkyl, C₁-C₂₀ cycloalkyl, C₁-C₂₀ alkenyl, C₁-C₂₀ alkinyl, aryl, heteroaryl, or
- optionally, a and d or b and f may be NR with R = C₁-C₂₀ alkyl, C₁-C₂₀ cycloalkyl, C₁-C₂₀ alkenyl, C₁-C₂₀ alkinyl, aryl, heteroaryl,
- wherein the bonds a-c, c-e, e-f and b-d, but not simultaneously a-c, c-e and e-f and not simultaneously a-c and c-e and not simultaneously c-e and e-f may be unsaturated,
- wherein the bonds a-c, c-e, e-f and b-d can be part of a saturated or unsaturated ring system which may also contain the heteroelements O, S, Se, N, P, Si, Ge, Sn, or
- the bonds a-c, c-e, e-f and b-d may be part of an aromatic or condensed aromatic ring system which may also contain the heteroelements O, S, Se, N,
- wherein the atom E is an element from the main group, preferably selected from the group N, P, As, Sb, though without being limited to these,
- wherein the structural element a-E-b may optionally be a component of a saturated or unsaturated ring system which may also contain the heteroelements O, S, Se, N, P, Si, Ge, Sn, or
- the structural element a-E-b may optionally be a component of an aromatic ring system which may also contain the heteroelements O, S, Se, N,
- wherein the metal M is a transition metal, preferably W or Mo; or 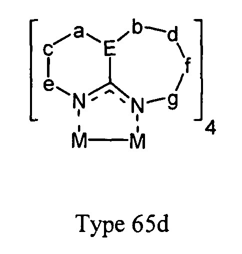
wherein
- the structural elements a-g may mean: a = -CR₁R₂-, b = -CR₃R₄-, c = -CR₅R₆-, d = -CR₇R₈-, e = -CR₉R₁₀-, f= CR₁₁R₁₂ and g = CR₁₃R₁₄, where R₁, R₂, R₃, R₄, R₅, R₆, R₇, R₈, R₉, R₁₀, R₁₁, R₁₂, R₁₃ and R₁₄ can, at the same time or independently from one another, be H, C₁-C₂₀ alkyl, C₁-C₂₀ cycloalkyl, C₁-C₂₀ alkenyl, C₁-C₂₀ alkinyl, aryl, heteroaryl, - NR₂ or -OR, preferably, R₁, R₃, R₅, R₇, R₉, R₁₁, R₁₃ = H and R₂, R₄, R₆, R₈, R₁₀, R₁₂, R₁₄ = C₁-C₂₀ alkyl, C₁-C₂₀ cycloalkyl, C₁-C₂₀ alkenyl, C₁-C₂₀ alkinyl, aryl, heteroaryl, - NR₂ or -OR, or
- at c, d and f, though not d and f simultaneously, C may be replaced by Si, or
- optionally, a or b or e or g may be NR with R = C₁-C₂₀ alkyl, C₁-C₂₀ cycloalkyl, C₁-C₂₀ alkenyl, C₁-C₂₀ alkinyl, aryl, heteroaryl, or
- optionally, a and g or b and e may be NR with R = C₁-C₂₀ alkyl, C₁-C₂₀ cycloalkyl, C₁-C₂₀ alkenyl, C₁-C₂₀ alkinyl, aryl, heteroaryl,
- wherein the bonds a-c, c-e, b-d, d-f and f-g, but not simultaneously a-c and c-e, and not simultaneously b-d, d-f and f-g, and not simultaneously b-d and d-f, and not simultaneously d-f and f-g, may be unsaturated,
- wherein the bonds a-c, c-e, b-d, d-f and f-g can be part of a saturated or unsaturated ring system which may also contain the heteroelements O, S, Se, N, P, Si, Ge, Sn, or
- the bonds a-c, c-e, b-d, d-f and f-g may be part of an aromatic or condensed aromatic ring system which may also contain the heteroelements O, S, Se, N,
- wherein the atom E is an element from the main group, preferably selected from the group N, P, As, Sb, though without being limited to these,
- wherein the structural element a-E-b may optionally be a component of a saturated or unsaturated ring system which may also contain the heteroelements O, S, Se, N, P, Si, Ge, Sn, or
- the structural element a-E-b may optionally be a component of an aromatic ring system which may also contain the heteroelements O, S, Se, N
- wherein the metal M is a transition metal, preferably W or Mo.

2. An electronic component with an electronically functionally effective region, **characterized in that** the electronically functionally effective region is at least one or multiple of neutral metal complexes with formula 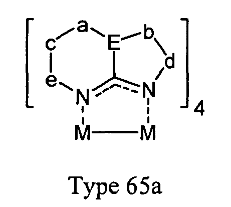 wherein
- the structural elements a-e may mean: a = -CR₁R₂-, b = -CR₃R₄-, c = -CR₅R₆-, d = -CR₇R₈- and e = -CR₉R₁₀-, where R₁, R₂, R₃, R₄, R₅, R₆, R₇, R₈, R₉ and R₁₀ are, at the same time or independently of one another, H, C₁-C₂₀ alkyl, C₁-C₂₀ cycloalkyl, C₁-C₂₀ alkenyl, C₁-C₂₀ alkinyl, aryl, heteroaryl, - NR₂ or -OR, preferably R₁, R₃, R₅, R₇, R₉ = H and R₂, R₄, R₆, R₈, R₁₀ = C₁-C₂₀ alkyl, C₁-C₂₀ cycloalkyl, C₁-C₂₀ alkenyl, C₁-C₂₀ alkinyl, aryl, heteroaryl, -NR₂ or -OR, or
- optionally, a or b or e or d may be NR with R = C₁-C₂₀ alkyl, C₁-C₂₀ cycloalkyl, C₁-C₂₀ alkenyl, C₁-C₂₀ alkinyl, aryl, heteroaryl, or
- optionally, a and d or b and e may be NR with R = C₁-C₂₀ alkyl, C₁-C₂₀ cycloalkyl, C₁-C₂₀ alkenyl, C₁-C₂₀ alkinyl, aryl, heteroaryl, or
- at c, C is replaced by Si,
- wherein the bonds b-d and c-e or b-d and a-c can, at the same time or independently of one another, be unsaturated,
- wherein the bonds b-d, a-c and c-e can, at the same time or independently of one another, be part of a saturated or unsaturated ring system which may also contain the heteroelements O, S, Se, N, P, Si, Ge, Sn, or
- wherein the bonds b-d, a-c and c-e can, at the same time or independently of one another, be part of an aromatic or condensed aromatic ring system which may also contain the heteroelements O, S, Se, N,
- wherein the atom E is an element from the main group, preferably selected from the group N, P, As, Sb, though without being limited to these,
- wherein the structural element a-E-b may optionally be a component of a saturated or unsaturated ring system which may also contain the heteroelements O, S, Se, N, P, Si, Ge, Sn, or
- the structural element a-E-b may optionally be a component of an aromatic ring system which may also contain the heteroelements O, S, Se, N, ,
- wherein the metal M is a transition metal, preferably W or Mo; 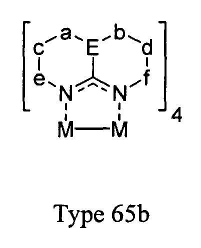
wherein
- the structural elements a-f may mean: a = -CR₁R₂-, b = -CR₃R₄-, c = -CR₅R₆-, d = -CR₇R₈-, e = -CR₉R₁₀- and f = CR₁₁R₁₂, where R₁, R₂, R₃, R₄, R₅, R₆, R₇, R₈, R₉, R₁₀, R₁₁ and R₁₂ are hydrogen, C₁-C₂₀ alkyl, C₁-C₂₀ cycloalkyl, C₁-C₂₀ alkenyl, C₁-C₂₀ alkinyl, aryl, heteroaryl, -NR₂ or -OR, preferably R₁, R₃, R₅, R₇, R₉, R₁₁ = H and R₂, R₄, R₆, R₈, R₁₀, R₁₂ = C₁-C₂₀ alkyl, C₁-C₂₀ cycloalkyl, C₁-C₂₀ alkenyl, C₁-C₂₀ alkinyl, aryl, heteroaryl, - NR₂ or -OR, or
- in the structural elements c and/or d, C may be replaced by Si, or
- optionally, a or b or e or f may be NR with R = C₁-C₂₀ alkyl, C₁-C₂₀ cycloalkyl, C₁-C₂₀ alkenyl, C₁-C₂₀ alkinyl, aryl, heteroaryl, or
- optionally, a and f or b and e may be NR with R = C₁-C₂₀ alkyl, C₁-C₂₀ cycloalkyl, C₁-C₂₀ alkenyl, C₁-C₂₀ alkinyl, aryl, heteroaryl,
- wherein the bonds a-c, b-d, c-e and d-f, but not simultaneously a-c and c-e and not simultaneously b-d and d-f may be unsaturated,
- wherein the bonds a-c, b-d, c-e and d-f can be part of a saturated or unsaturated ring system which may also contain the heteroelements O, S, Se, N, P, Si, Ge, Sn, or
- the bonds a-c, b-d, c-e and d-f may be part of an aromatic or condensed aromatic ring system which may also contain the heteroelements O, S, Se, N,
- wherein the atom E is an element from the main group, preferably selected from the group N, P, As, Sb, though without being limited to these,
- wherein the structural element a-E-b may optionally be a component of a saturated or unsaturated ring system which may also contain the heteroelements O, S, Se, N, P, Si, Ge, Sn, or
- the structural element a-E-b may optionally be a component of an aromatic ring system which may also contain the heteroelements O, S, Se, N,
- wherein the metal M is a transition metal, preferably W or Mo; 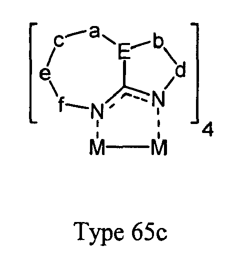
wherein
- the structural elements a-f may mean: a = -CR₁R₂-, b = -CR₃R₄-, c = -CR₅R₆-, d = -CR₇R₈-, e = -CR₉R₁₀- and f= CR₁₁R₁₂, where R₁, R₂, R₃, R₄, R₅, R₆, R₇, R₈, R₉, R₁₀, R₁₁ and R₁₂ can, at the same time or independently from one another, be H, C₁-C₂₀ alkyl, C₁-C₂₀ cycloalkyl, C₁-C₂₀ alkenyl, C₁-C₂₀ alkinyl, aryl, heteroaryl, - NR₂ or -OR, preferably R₁, R₃, R₅, R₇, R₉, R₁₁ = H and R₂, R₄, R₆, R₈, R₁₀, R₁₂ = C₁-C₂₀ alkyl, C₁-C₂₀ cycloalkyl, C₁-C₂₀ alkenyl, C₁-C₂₀ alkinyl, aryl, heteroaryl, - NR₂ or -OR, or
- at c or e, C may be replaced by Si, or
- optionally, a or b or d or f may be NR with R = C₁-C₂₀ alkyl, C₁-C₂₀ cycloalkyl, C₁-C₂₀ alkenyl, C₁-C₂₀ alkinyl, aryl, heteroaryl, or
- optionally, a and d or b and f may be NR with R = C₁-C₂₀ alkyl, C₁-C₂₀ cycloalkyl, C₁-C₂₀ alkenyl, C₁-C₂₀ alkinyl, aryl, heteroaryl,
- wherein the bonds a-c, c-e, e-f and b-d, but not simultaneously a-c, c-e and e-f and not simultaneously a-c and c-e and not simultaneously c-e and e-f may be unsaturated,
- wherein the bonds a-c, c-e, e-f and b-d can be part of a saturated or unsaturated ring system which may also contain the heteroelements O, S, Se, N, P, Si, Ge, Sn, or
- the bonds a-c, c-e, e-f and b-d may be part of an aromatic or condensed aromatic ring system which may also contain the heteroelements O, S, Se, N,
- wherein the atom E is an element from the main group, preferably selected from the group N, P, As, Sb, though without being limited to these,
- wherein the structural element a-E-b may optionally be a component of a saturated or unsaturated ring system which may also contain the heteroelements O, S, Se, N, P, Si, Ge, Sn, or
- the structural element a-E-b may optionally be a component of an aromatic ring system which may also contain the heteroelements O, S, Se, N,
- wherein the metal M is a transition metal, preferably W or Mo; or 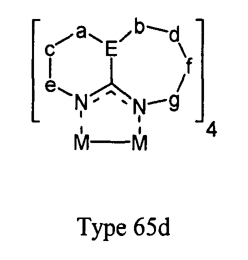
wherein
- the structural elements a-g may mean: a = -CR₁R₂-, b = -CR₃R₄-, c = -CR₅R₆-, d = -CR₇R₈-, e = -CR₉R₁₀-, f= CR₁₁R₁₂ and g = CR₁₃R₁₄, where R₁, R₂, R₃, R₄, R₅, R₆, R₇, R₈, R₉, R₁₀, R₁₁, R₁₂, R₁₃ and R₁₄ can, at the same time or independently from one another, be H, C₁-C₂₀ alkyl, C₁-C₂₀ cycloalkyl, C₁-C₂₀ alkenyl, C₁-C₂₀ alkinyl, aryl, heteroaryl, - NR₂ or -OR, preferably, R₁, R₃, R₅, R₇, R₉, R₁₁, R₁₃ = H and R₂, R₄, R₆, R₈, R₁₀, R₁₂, R₁₄ = C₁-C₂₀ alkyl, C₁-C₂₀ cycloalkyl, C₁-C₂₀ alkenyl, C₁-C₂₀ alkinyl, aryl, heteroaryl, - NR₂ or -OR, or
- at c, d and f, though not d and f simultaneously, C may be replaced by Si, or
- optionally, a or b or e or g may be NR with R = C₁-C₂₀ alkyl, C₁-C₂₀ cycloalkyl, C₁-C₂₀ alkenyl, C₁-C₂₀ alkinyl, aryl, heteroaryl, or
- optionally, a and g or b and e may be NR with R = C₁-C₂₀ alkyl, C₁-C₂₀ cycloalkyl, C₁-C₂₀ alkenyl, C₁-C₂₀ alkinyl, aryl, heteroaryl,
- wherein the bonds a-c, c-e, b-d, d-f and f-g, but not simultaneously a-c and c-e, and not simultaneously b-d, d-f and f-g, and not simultaneously b-d and d-f, and not simultaneously d-f and f-g, may be unsaturated,
- wherein the bonds a-c, c-e, b-d, d-f and f-g can be part of a saturated or unsaturated ring system which may also contain the heteroelements O, S, Se, N, P, Si, Ge, Sn, or
- the bonds a-c, c-e, b-d, d-f and f-g may be part of an aromatic or condensed aromatic ring system which may also contain the heteroelements O, S, Se, N,
- wherein the atom E is an element from the main group, preferably selected from the group N, P, As, Sb, though without being limited to these,
- wherein the structural element a-E-b may optionally be a component of a saturated or unsaturated ring system which may also contain the heteroelements O, S, Se, N, P, Si, Ge, Sn, or
- the structural element a-E-b may optionally be a component of an aromatic ring system which may also contain the heteroelements O, S, Se, N
- wherein the metal M is a transition metal, preferably W or Mo.

3. The electronic component according to claim 2, **characterized in that** the electronically functionally effective region comprises an organic semiconducting matrix material which is doped with the at least one or multiple of neutral metal complexes as n-dopant.

4. The electronic component according to claim 2 or 3 in the form of an organic light-emitting diode (OLED), of a photovoltaic cell, of an organic solar cell, of an organic diode or an organic field effect transistor in which the semiconducting organic material doped with at the at least one or multiple of neutral metal complexes is an electronically functionally active part of the electronic component.

## Revendications

1. Utilisation d'un complexe métallique comme dopant en vue du dopage d'un matériau de matrice semi-conducteur organique pour la modification des propriétés électriques de ce dernier, le complexe métallique représentant par rapport au matériau de matrice un dopant de type n, ou utilisation d'un complexe métallique pour la fabrication d'un composant électronique avec une zone active électroniquement fonctionnelle contenant le complexe métallique, le complexe métallique étant un complexe métallique neutre riche en électrons de formule 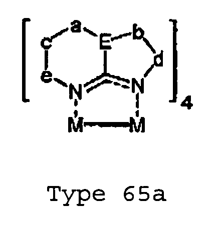 étant donné que
- les éléments de structure a-e peuvent avoir la signification suivante : a = -CR₁R₂-, b = -CR₃R₄-, c = -CR₅-R₆-, d = -CR₇R₈- et e = -CR₉R₁₀-, R₁, R₂, R₃, R₄, R₅, R₆, R₇, R₈, R₉ et R₁₀ étant, simultanément ou indépendamment les uns des autres, H, un alkyle en C₁-C₂₀, un cycloalkyle en C₁-C₂₀, un alcényle en C₁-C₂₀, un alcynyle en C₁-C₂₀, un aryle, un hétéroaryle, NR₂ ou -OR, R₁, R₃, R₅, R₇, R₉, étant de préférence H et R₂, R₄, R₆, R₈, R₁₀ étant un alkyle en C₁-C₂₀, un cycloalkyle en C₁-C₂₀, un alcényle en C₁-C₂₀, un alcynyle en C₁-C₂₀, un aryle, un hétéroaryle, -NR₂ ou -OR, ou
- au choix, a ou b ou e ou d pouvant être NR avec R = un alkyle en C₁-C₂₀, un cycloalkyle en C₁-C₂₀, un alcényle en C₁-C₂₀, un alcynyle en C₁-C₂₀, un aryle, un hétéroaryle, ou
- au choix, a et d ou b et e pouvant être NR avec R = un alkyle en C₁-C₂₀, un cycloalkyle en C₁-C₂₀, un alcényle en C₁-C₂₀, un alcynyle en C₁-C₂₀, un aryle, un hétéroaryle, ou
- pour c, C est remplacé par Si,
- les liaisons b-d et c-e ou b-d et a-c pouvant être, simultanément ou indépendamment les unes des autres, insaturées,
- les liaisons b-d, a-c et c-e pouvant faire partie, simultanément ou indépendamment les unes des autres, d'un système de cycles, saturé ou insaturé, qui peut également contenir les hétéro-éléments O, S, Se, N, P, Si, Ge, Sn, ou
- les liaisons b-d, a-c et c-e pouvant faire partie, simultanément ou indépendamment les unes des autres, d'un système de cycles aromatique condensé ou aromatique qui peut également contenir les hétéro-éléments O, S, Se, N, ou
- l'atome E étant un élément des groupes principaux sélectionné de préférence dans le groupe N, P, As, Sb, sans pour autant y être limité,
- l'élément de structure a-E-b pouvant être au choix un constituant d'un système de cycles, saturé ou insaturé, qui peut également contenir les hétéro-éléments O, S, Se, N, P, Si, Ge, Sn, ou
- l'élément de structure a-E-b pouvant être au choix un constituant d'un système de cycles aromatique qui peut également contenir les hétéro-éléments O, S, Se, N,
- le métal M étant un métal de transition, de préférence W ou Mo ; 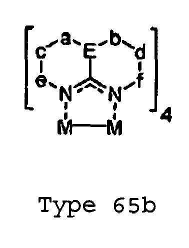
dans lequel
- les éléments de structure a-f peuvent avoir la signification suivante : a = -CR₁R₂-, b = -CR₃R₄-, c = -CR₅-R₆-, d = -CR₇R₈-, e = -CR₉R₁₀- et f = CR₁₁R₁₂, R₁, R₂, R₃, R₄, R₅, R₆, R₇, R₈, R₉, R₁₀, R₁₁ et R₁₂ pouvant être l'hydrogène, un alkyle en C₁-C₂₀, un cycloalkyle en C₁-C₂₀, un alcényle en C₁-C₂₀, un alcynyle en C₁-C₂₀, un aryle, un hétéroaryle, -NR₂ ou -OR, R₁, R₃, R₅, R₇, R₉, R₁₁ étant de préférence = H et R₂, R₄, R₆, R₈, R₁₀, R₁₂ étant = un alkyle en C₁-C₂₀, un cycloalkyle en C₁-C₂₀, un alcényle en C₁-C₂₀, un alcynyle en C₁-C₂₀, un aryle, un hétéroaryle, - NR₂ ou -OR, ou
- dans le cas des éléments de structure c et/ou d, C pouvant être remplacé par Si, ou
- au choix, a ou b ou e ou f pouvant être NR avec R = un alkyle en C₁-C₂₀, un cycloalkyle en C₁-C₂₀, un alcényle en C₁-C₂₀, un alcynyle en C₁-C₂₀, un aryle, un hétéroaryle, ou
- au choix, a ou f ou b et e pouvant être NR avec R = un alkyle en C₁-C₂₀, un cycloalkyle en C₁-C₂₀, un alcényle en C₁-C₂₀, un alcynyle en C₁-C₂₀, un aryle, un hétéroaryle,
- les liaisons a-c, b-d, c-e et d-f, mais non simultanément a-c et c-e et non simultanément b-d et d-f, pouvant être insaturées,
- les liaisons a-c, b-d, c-e et d-f pouvant faire partie d'un système de cycles, saturé ou non saturé, qui peut également contenir les hétéro-éléments O, S, Se, N, P, Si, Ge, Sn, ou
- les liaisons a-c, b-d, c-e et d-f pouvant faire partie d'un système de cycles aromatique ou condensé aromatique qui peut également contenir les hétéro-éléments O, S, Se, N, ou
- l'atome E étant un élément des groupes principaux sélectionné de préférence dans le groupe N, P, As, Sb, sans pour autant y être limité,
- l'élément de structure a-E-b pouvant être au choix un constituant d'un système de cycles, saturé ou insaturé, qui peut également contenir les hétéro-éléments O, S, Se, N, P, Si, Ge, Sn, ou
- l'élément de structure a-E-b pouvant être au choix un constituant d'un système de cycles aromatique qui peut également contenir les hétéro-éléments O, S, Se, N,
- le métal M étant un métal de transition, de préférence W ou Mo ; 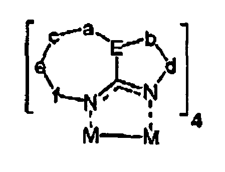 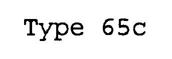
- les éléments de structure a-f pouvant avoir la signification suivante : a = -CR₁R₂-, b = -CR₃R₄-, c = -CR₅-R₆-, d = -CR₇R₈-, e = -CR₉R₁₀- et f = CR₁₁R₁₂, R₁, R₂, R₃, R₄, R₅, R₆, R₇, R₈, R₉, R₁₀, R₁₁ et R₁₂ pouvant être, simultanément ou indépendamment les uns des autres, H, un alkyle en C₁-C₂₀, un cycloalkyle en C₁-C₂₀, un alcényle en C₁-C₂₀, un alcynyle en C₁-C₂₀, un aryle, un hétéroaryle, -NR₂ ou -OR; R₁, R₃, R₅, R₇, R₉, R₁₁ étant, de préférence, H et R₂, R₄, R₆, R₈, R₁₀, R₁₂ étant un alkyle en C₁-C₂₀, un cycloalkyle en C₁-C₂₀, un alcényle en C₁-C₂₀, un alcynyle en C₁-C₂₀, un aryle, un hétéroaryle, - NR₂ ou -OR, ou
- pour c ou e, C pouvant être remplacé par Si, ou
- au choix, a ou b ou d ou f pouvant être NR avec R = un alkyle en C₁-C₂₀, un cycloalkyle en C₁-C₂₀, un alcényle en C₁-C₂₀, un alcynyle en C₁-C₂₀, un aryle, un hétéroaryle, ou
- au choix, a et d ou b et f pouvant être NR avec R = un alkyle en C₁-C₂₀, un cycloalkyle en C₁-C₂₀, un alcényle en C₁-C₂₀, un alcynyle en C₁-C₂₀, un aryle, un hétéroaryle,
- les liaisons a-c, c-e, e-f et b-d, mais non simultanément a-c et c-e et e-f et non simultanément a-c et c-e et non simultanément c-e et e-f, pouvant être insaturées,
- les liaisons a-c, c-e, e-f et b-d pouvant faire partie d'un système de cycles, saturé ou insaturé, qui peut également contenir les hétéro-éléments O, S, Se, N, P, Si, Ge, Sn, ou
- les liaisons a-c, c-e, e-f et b-d pouvant faire partie d'un système de cycles aromatique ou condensé aromatique qui peut également contenir les hétéro-éléments O, S, Se, N, ou
- l'atome E étant un élément des groupes principaux sélectionné de préférence dans le groupe N, P, As, Sb, sans pour autant y être limité,
- l'élément de structure a-E-b pouvant être au choix un constituant d'un système de cycles, saturé ou insaturé, qui peut également contenir les hétéro-éléments O, S, Se, N, P, Si, Ge, Sn, ou
- l'élément de structure a-E-b pouvant être au choix un constituant d'un système de cycles aromatique qui peut également contenir les hétéro-éléments O, S, Se, N,
- le métal M étant un métal de transition, de préférence W ou Mo ; ou 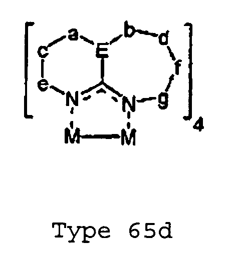
- les éléments de structure a-g pouvant avoir la signification suivante : a = -CR₁R₂-, b = -CR₃R₄-, c = -CR₅-R₆-, d = -CR₇R₈-, e = -CR₉R₁₀-, f = CR₁₁R₁₂ et g = CR₁₃R₁₄, R₁, R₂, R₃, R₄, R₅, R₆, R₇, R₈, R₉, R₁₀, R₁₁, R₁₂, R₁₃ et R₁₄ pouvant être, simultanément ou indépendamment les uns des autres, H, un alkyle en C₁-C₂₀, un cycloalkyle en C₁-C₂₀, un alcényle en C₁-C₂₀, un alcynyle en C₁-C₂₀, un aryle, un hétéroaryle, - NR₂ ou -OR; R₁, R₃, R₅, R₇, R₉, R₁₁, et R₁₃ étant H et R₂, R₄, R₆, R₈, R₁₀, R₁₂ et R₁₄ étant un alkyle en C₁-C₂₀, un cycloalkyle en C₁-C₂₀, un alcényle en C₁-C₂₀, un alcynyle en C₁-C₂₀, un aryle, un hétéroaryle, - NR₂ ou -OR, ou
- pour c, d et f, toutefois pas pour d et f simultanément, C pouvant être remplacé par Si, ou
- au choix, a ou b ou e ou g pouvant être NR avec R = un alkyle en C₁-C₂₀, un cycloalkyle en C₁-C₂₀, un alcényle en C₁-C₂₀, un alcynyle en C₁-C₂₀, un aryle, un hétéroaryle, ou
- au choix, a et g ou b et e pouvant être NR avec R = un alkyle en C₁-C₂₀, un cycloalkyle en C₁-C₂₀, un alcényle en C₁-C₂₀, un alcynyle en C₁-C_{20,} un aryle, un hétéroaryle, ou
- les liaisons a-c, c-e, b-d, d-f et f-g, mais non simultanément a-c et c-e, et non simultanément b-d, d-f et f-g, et non simultanément b-d et d-f, et non simultanément d-f et f-g, pouvant être insaturées,
- les liaisons a-c, c-e, b-d, d-f et f-g pouvant faire partie d'un système de cycles, saturé ou insaturé, qui peut également contenir les hétéro-éléments O, S, Se, N, P, Si, Ge, Sn, ou
- les liaisons a-c, c-e, b-d, d-f et f-g pouvant faire partie d'un système de cycles aromatique ou condensé aromatique qui peut également contenir les hétéro-éléments O, S, Se, N, ou
- l'atome E étant un élément des groupes principaux sélectionné de préférence dans le groupe N, P, As, Sb, sans pour autant y être limité,
- l'élément de structure a-E-b pouvant être au choix un constituant d'un système de cycles, saturé ou insaturé, qui peut également contenir les hétéro-éléments O, S, Se, N, P, Si, Ge, Sn, ou
- l'élément de structure a-E-b pouvant être au choix un constituant d'un système de cycles aromatique qui peut également contenir les hétéro-éléments O, S, Se, N,
- le métal M étant un métal de transition, de préférence W ou Mo.

2. Composant électronique avec une zone active électroniquement fonctionnelle, **caractérisé en ce que** la zone active électroniquement fonctionnelle est au moins un ou plusieurs complexe(s) métallique(s) neutre(s) de formule 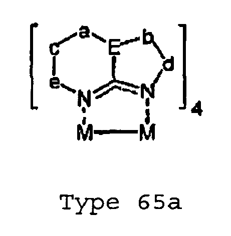 étant donné que
- les éléments de structure a-e peuvent avoir la signification suivante : a = -CR₁R₂-, b = -CR₃R₄-, c = -CR₅-R₆-, d = -CR₇R₈- et e = -CR₉R₁₀-, R₁, R₂, R₃, R₄, R₅, R₆, R₇, R₈, R₉ et R₁₀ étant, simultanément ou indépendamment les uns des autres, H, un alkyle en C₁-C₂₀, un cycloalkyle en C₁-C₂₀, un alcényle en C₁-C₂₀, un alcynyle en C₁-C₂₀, un aryle, un hétéroaryle, NR₂ ou -OR, R₁, R₃, R₅, R₇, R₉, étant de préférence H et R₂, R₄, R₆, R₈, R₁₀ étant un alkyle en C₁-C₂₀, un cycloalkyle en C₁-C₂₀, un alcényle en C₁-C₂₀, un alcynyle en C₁-C₂₀, un aryle, un hétéroaryle, -NR₂ ou -OR, ou
- au choix, a ou b ou e ou d pouvant être NR avec R = un alkyle en C₁-C₂₀, un cycloalkyle en C₁-C₂₀, un alcényle en C₁-C₂₀, un alcynyle en C₁-C_{20,} un aryle, un hétéroaryle, ou
- au choix, a et d ou b et e pouvant être NR avec R = un alkyle en C₁-C₂₀, un cycloalkyle en C₁-C₂₀, un alcényle en C₁-C₂₀, un alcynyle en C₁-C_{20,} un aryle, un hétéroaryle, ou
- pour c, C est remplacé par Si,
- les liaisons b-d et c-e ou b-d et a-c pouvant être, simultanément ou indépendamment les unes des autres, insaturées,
- les liaisons b-d, a-c et c-e pouvant faire partie, simultanément ou indépendamment les unes des autres, d'un système de cycles, saturé ou insaturé, qui peut également contenir les hétéro-éléments O, S, Se, N, P, Si, Ge, Sn, ou
- les liaisons b-d, a-c et c-e pouvant faire partie, simultanément ou indépendamment les unes des autres, d'un système de cycles aromatique condensé ou aromatique qui peut également contenir les hétéro-éléments O, S, Se, N, ou
- l'atome E étant un élément des groupes principaux sélectionné de préférence dans le groupe N, P, As, Sb, sans pour autant y être limité,
- l'élément de structure a-E-b pouvant être au choix un constituant d'un système de cycles, saturé ou insaturé, qui peut également contenir les hétéro-éléments O, S, Se, N, P, Si, Ge, Sn, ou
- l'élément de structure a-E-b pouvant être au choix un constituant d'un système de cycles aromatique qui peut également contenir les hétéro-éléments O, S, Se, N,
- le métal M étant un métal de transition, de préférence W ou Mo ; 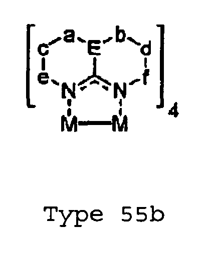
dans lequel
- les éléments de structure a-f peuvent avoir la signification suivante : a = -CR₁R₂-, b = -CR₃R₄-, c = -CR₅-R₆-, d = -CR₇R₈-, e = -CR₉R₁₀- et f = CR₁₁R₁₂, R₁, R₂, R₃, R₄, R₅, R₆, R₇, R₈, R₉, R₁₀, R₁₁ et R₁₂ pouvant être l'hydrogène, un alkyle en C₁-C₂₀, un cycloalkyle en C₁-C₂₀, un alcényle en C₁-C₂₀, un alcynyle en C₁-C₂₀, un aryle, un hétéroaryle, -NR₂ ou -OR, R₁, R₃, R₅, R₇, R₉, R₁₁ étant de préférence = H et R₂, R₄, R₆, R₈, R₁₀, R₁₂ étant = un alkyle en C₁-C₂₀, un cycloalkyle en C₁-C₂₀, un alcényle en C₁-C₂₀, un alcynyle en C₁-C₂₀, un aryle, un hétéroaryle, - NR₂ ou -OR, ou
- dans le cas des éléments de structure c et/ou d, C pouvant être remplacé par Si, ou
- au choix, a ou b ou e ou f pouvant être NR avec R = un alkyle en C₁-C₂₀, un cycloalkyle en C₁-C₂₀, un alcényle en C₁-C₂₀, un alcynyle en C₁-C₂₀, un aryle, un hétéroaryle, ou
- au choix, a ou f ou b et e pouvant être NR avec R = un alkyle en C₁-C₂₀, un cycloalkyle en C₁-C₂₀, un alcényle en C₁-C₂₀, un alcynyle en C₁-C₂₀, un aryle, un hétéroaryle,
- les liaisons a-c, b-d, c-e et d-f, mais non simultanément a-c et c-e et non simultanément b-d et d-f, pouvant être insaturées,
- les liaisons a-c, b-d, c-e et d-f pouvant faire partie d'un système de cycles, saturé ou non saturé, qui peut également contenir les hétéro-éléments O, S, Se, N, P, Si, Ge, Sn, ou
- les liaisons a-c, b-d, c-e et d-f pouvant faire partie d'un système de cycles aromatique ou condensé aromatique qui peut également contenir les hétéro-éléments O, S, Se, N, ou
- l'atome E étant un élément des groupes principaux sélectionné de préférence dans le groupe N, P, As, Sb, sans pour autant y être limité,
- l'élément de structure a-E-b pouvant être au choix un constituant d'un système de cycles, saturé ou insaturé, qui peut également contenir les hétéro-éléments O, S, Se, N, P, Si, Ge, Sn, ou
- l'élément de structure a-E-b pouvant être au choix un constituant d'un système de cycles aromatique qui peut également contenir les hétéro-éléments O, S, Se, N,
- le métal M étant un métal de transition, de préférence W ou Mo ; 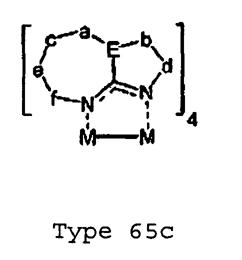
dans lequel
- les éléments de structure a-f peuvent avoir la signification suivante : a = -CR₁R₂-, b = -CR₃R₄-, c = -CR₅-R₆-, d = -CR₇R₈-, e = -CR₉R₁₀- et f = CR₁₁R₁₂, R₁, R₂, R₃, R₄, R₅, R₆, R₇, R₈, R₉, R₁₀, R₁₁ et R₁₂ pouvant être, simultanément ou indépendamment les uns des autres, H, un alkyle en C₁-C₂₀, un cycloalkyle en C₁-C₂₀, un alcényle en C₁-C₂₀, un alcynyle en C₁-C₂₀, un aryle, un hétéroaryle, -NR₂ ou -OR; R₁, R₃, R₅, R₇, R₉, R₁₁ étant, de préférence, H et R₂, R₄, R₆, R₈, R₁₀, R₁₂ étant un alkyle en C₁-C₂₀, un cycloalkyle en C₁-C₂₀, un alcényle en C₁-C₂₀, un alcynyle en C₁-C₂₀, un aryle, un hétéroaryle, - NR₂ ou -OR, ou
- pour c ou e, C pouvant être remplacé par Si, ou
- au choix, a ou b ou d ou f pouvant être NR avec R = un alkyle en C₁-C₂₀, un cycloalkyle en C₁-C₂₀, un alcényle en C₁-C₂₀, un alcynyle en C₁-C₂₀, un aryle, un hétéroaryle, ou
- au choix, a et d ou b et f pouvant être NR avec R = un alkyle en C₁-C₂₀, un cycloalkyle en C₁-C₂₀, un alcényle en C₁-C₂₀, un alcynyle en C₁-C₂₀, un aryle, un hétéroaryle,
- les liaisons a-c, c-e, e-f et b-d, mais non simultanément a-c, c-e et e-f et non simultanément a-c et c-e et non simultanément c-e et e-f, pouvant être insaturées,
- les liaisons a-c, c-e, e-f et b-d pouvant faire partie d'un système de cycles, saturé ou insaturé, qui peut également contenir les hétéro-éléments O, S, Se, N, P, Si, Ge, Sn, ou
- les liaisons a-c, c-e, e-f et b-d pouvant faire partie d'un système de cycles aromatique ou condensé aromatique qui peut également contenir les hétéro-éléments O, S, Se, N, ou
- l'atome E étant un élément des groupes principaux sélectionné de préférence dans le groupe N, P, As, Sb, sans pour autant y être limité,
- l'élément de structure a-E-b pouvant être au choix un constituant d'un système de cycles, saturé ou insaturé, qui peut également contenir les hétéro-éléments O, S, Se, N, P, Si, Ge, Sn, ou
- l'élément de structure a-E-b pouvant être au choix un constituant d'un système de cycles aromatique qui peut également contenir les hétéro-éléments O, S, Se, N,
- le métal M étant un métal de transition, de préférence W ou Mo ; ou 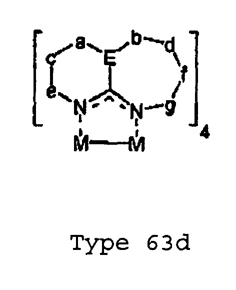
- les éléments de structure a-g pouvant avoir la signification suivante : a = -CR₁R₂-, b = -CR₃R₄-, c = -CR₅-R₆-, d = -CR₇R₈-, e = -CR₉R₁₀-, f = CR₁₁R₁₂ et g = CR₁₃R₁₄, R₁, R₂, R₃, R₄, R₅, R₆, R₇, R₈, R₉, R₁₀, R₁₁, R₁₂, R₁₃ et R₁₄ pouvant être, simultanément ou indépendamment les uns des autres, H, un alkyle en C₁-C₂₀, un cycloalkyle en C₁-C₂₀, un alcényle en C₁-C₂₀, un alcynyle en C₁-C₂₀, un aryle, un hétéroaryle, - NR₂ ou -OR; R₁, R₃, R₅, R₇, R₉, R₁₁, et R₁₃ étant H et R₂, R₄, R₆, R₈, R₁₀, R₁₂ et R₁₄ étant un alkyle en C₁-C₂₀, un cycloalkyle en C₁-C_{20,} un alcényle en C₁-C₂₀, un alcynyle en C₁-C₂₀, un aryle, un hétéroaryle, - NR₂ ou -OR, ou
- pour c, d et f, toutefois pas pour d et f simultanément, C pouvant être remplacé par Si, ou
- au choix, a ou b ou e ou g pouvant être NR avec R = un alkyle en C₁-C₂₀, un cycloalkyle en C₁-C₂₀, un alcényle en C₁-C₂₀, un alcynyle en C₁-C₂₀, un aryle, un hétéroaryle, ou
- au choix, a et g ou b et e pouvant être NR avec R = un alkyle en C₁-C₂₀, un cycloalkyle en C₁-C₂₀, un alcényle en C₁-C₂₀, un alcynyle en C₁-C₂₀, un aryle, un hétéroaryle, ou
- les liaisons a-c, c-e, b-d, d-f et f-g, mais non simultanément a-c et c-e, et non simultanément b-d, d-f et f-g, et non simultanément b-d et d-f, et non simultanément d-f et f-g, pouvant être insaturées,
- les liaisons a-c, c-e, b-d, d-f et f-g pouvant faire partie d'un système de cycles, saturé ou insaturé, qui peut également contenir les hétéro-éléments O, S, Se, N, P, Si, Ge, Sn, ou
- les liaisons a-c, c-e, b-d, d-f et f-g pouvant faire partie d'un système de cycles aromatique ou condensé aromatique qui peut également contenir les hétéro-éléments O, S, Se, N, ou
- l'atome E étant un élément des groupes principaux sélectionné de préférence dans le groupe N, P, As, Sb, sans pour autant y être limité,
- l'élément de structure a-E-b pouvant être au choix un constituant d'un système de cycles, saturé ou insaturé, qui peut également contenir les hétéro-éléments O, S, Se, N, P, Si, Ge, Sn, ou
- l'élément de structure a-E-b pouvant être au choix un constituant d'un système de cycles aromatique qui peut également contenir les hétéro-éléments O, S, Se, N,
- le métal M étant un métal de transition, de préférence W ou Mo.

3. Composant électronique selon la revendication 2, **caractérisé en ce que** la zone électroniquement effective présente un matériau de matrice semi-conducteur organique qui est dopé avec au moins un ou plusieurs complexe(s) métallique(s) neutre(s) comme dopant de type n.

4. Composant électronique selon la revendication 2 ou 3, sous forme d'une diode électroluminescente organique (DELO), d'une cellule photovoltaïque, d'une cellule solaire organique, d'une diode organique ou d'un transistor à effet de champ organique, dans lequel le matériau semi-conducteur organique, dopé à l'aide du au moins un complexe métallique neutre représente un métal actif électroniquement fonctionnel du composant électronique.
